(19) Europäisches Patentamt
European Patent Office
Office européen des brevets

(11) EP 4 640 742 A1

(12) EUROPEAN PATENT APPLICATION
published in accordance with Art. 153(4) EPC

(43) Date of publication:
**29.10.2025 Bulletin 2025/44**

(21) Application number: **23907121.0**

(22) Date of filing: **21.12.2023**

(51) International Patent Classification (IPC):
***C08G 64/06** (2006.01)* ***C08L 69/00** (2006.01)*
***H05K 1/03** (2006.01)*

(52) Cooperative Patent Classification (CPC):
**C08G 64/06; C08L 69/00; H05K 1/03**

(86) International application number:
**PCT/JP2023/045833**

(87) International publication number:
**WO 2024/135761 (27.06.2024 Gazette 2024/26)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **21.12.2022 JP 2022204417**

(71) Applicant: **Idemitsu Kosan Co.,Ltd.**
**Tokyo 100-8321 (JP)**

(72) Inventors:
- **FUKITA, Momoe**
  **Tokyo 100-8321 (JP)**
- **CHIBA, Kazunori**
  **Tokyo 100-8321 (JP)**
- **HIKOSAKA, Takaaki**
  **Tokyo 100-8321 (JP)**
- **MORISHITA, Hironobu**
  **Tokyo 100-8321 (JP)**

(74) Representative: **Gille Hrabal Partnerschaftsgesellschaft mbB**
**Patentanwälte**
**Brucknerstraße 20**
**40593 Düsseldorf (DE)**

(54) **ELECTRONIC SUBSTRATE MATERIAL, RESIN, AND METHOD FOR MANUFACTURING RESIN**

(57) An electronic substrate material containing a resin having a structure represented by Formula (UN1).

[Formula 1]

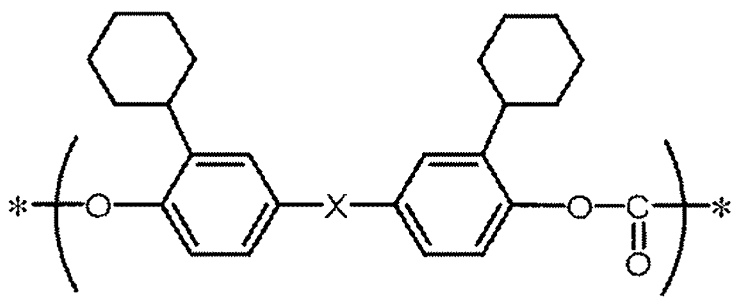

(UN1)

In Formula (UN1): X represents a single bond, -O-, -S-, -SO-, $-SO_2-$, or an organic group having 1 to 20 carbon atoms; and * each represent a bond.

EP 4 640 742 A1

## Description

### TECHNICAL FIELD

The present invention relates to an electronic substrate material, a resin, and a method for producing a resin.

### BACKGROUND ART

Next-generation high-speed communication technologies, known as 5G and even 6G, have features such as "high speed and large capacity," "multiple simultaneous connections," and "ultra-low latency". Such technologies are being introduced into a variety of communication networks in fields such as electrical and electronic equipment, mobility such as automobiles, and medical care, bringing about changes in the economy and society. Electronic circuit boards or semiconductor package substrates (hereinafter referred to as electronic substrates) used in electronic devices such as communication devices in the above fields also face various challenges in improving their performance. One of the major issues is that as the volume of information and communication increases, the frequencies used for communication become higher. As a result, materials used in current electronic substrates have a large transmission loss, which is a rate at which electrical signal energy is converted into heat and lost, resulting in problems of energy loss and heat generation from the substrate.

Transmission loss consists of two components: conductor loss and dielectric loss. The dielectric loss is proportional to the square root of the dielectric constant (Dk) of the dielectric and to the dissipation factor (Df) of the dielectric. Thus, in order to reduce, for instance, the transmission loss of the electronic substrate in which an insulating material is used, it is necessary to reduce the dielectric constant and dissipation factor of the material used as the insulating material. In addition, there is a trend to reduce the roughness of an interface between the substrate and the metal wiring in order to reduce conductor loss, leading to an increased demand for better adhesion to metal foil or metal plating.

Furthermore, electronic substrate materials are required to have not only reduced transmission loss but also various other properties. Examples thereof include high heat resistance that can withstand high-temperature solder reflow, and low thermal expansion to prevent warping of the substrate due to the difference in thermal expansion coefficient between the copper circuit and the insulating layer. Other examples thereof include high solvent solubility, low solution viscosity, and filler dispersibility for applying the insulating material to the substrate and molding it. Still other examples thereof include high solvent solubility, low viscosity, and filler dispersibility for forming the thin film used in laminating the wiring layer, and small changes in dielectric properties under the operating environment such as temperature or humidity.

As insulating materials therefor, resins such as thermoplastic resins including liquid crystal polymers, polyphenylene ether, polyimide, and fluorine resin, or thermosetting resins including epoxy resin and maleimide resin, have been improved and developed for electronic substrates for various applications.

Among these resins, polycarbonate resin has been used as a material for molded products in various industrial fields because of its excellent mechanical properties, thermal properties, electrical properties, transparency, and the like. However, when polycarbonate resin is used for an electronic substrate for the above-mentioned high frequencies, the dielectric properties of typical bisphenol A polycarbonate would worsen the transmission loss, and its solubility in organic solvents and solution stability are poor, making it difficult to use the polycarbonate resin in insulating coating solutions for fine wiring or the molding of thin insulating films. Furthermore, bisphenol Z polycarbonate, which is used for coating and molding of electrophotographic photoreceptors, etc., also has insufficient dielectric properties. Conventional polycarbonate resins have not satisfied these requirements in a balanced manner.

Patent Literature 1 describes a conductive film including a conducting film and a substrate made of a polycarbonate resin, the polycarbonate resin having low dielectric properties and bendability that enable the formation of an antenna with low transmission loss and being made from one or two specific types of bisphenols as raw materials having good adhesion to the conducting film. The object of Patent Literature 1 is similar to that of the invention in that the dielectric constant and the dissipation factor are reduced. However, Patent Literature 1 is intended for use in antennas, which is different from the object of the invention. In addition, the production method of the molded product in Patent Literature 1 is injection molding or extrusion molding, and Patent Literature 1 fails to describe high solvent solubility or low solution viscosity for the coating and molding of the invention. Patent Literature 1 also fails to describe a polycarbonate resin into which a thermosetting group is introduced.

Patent Literature 2 describes that a polycarbonate resin produced using one or two specific types of bisphenols as raw materials is excellent in microwave or millimeter-wave band transmission, and that such a polycarbonate resin can be used as a thermoplastic resin composition and a formed product thereof excellent in heat resistance and flame retardancy, as well as a housing for a communication device with a built-in microwave or millimeter-wave antenna and a communication device including that housing. Patent Literature 2 is similar to the invention in that low dielectric properties and high heat resistance are exhibited and transmission loss is reduced. However, the housing for a communication device with a built-in antenna is a box that houses a communication device, and is different from a wiring board and an electronic

substrate. Furthermore, in Patent Literature 2, there are limitation on the intended use and the method of producing the film or formed product (injection molding or extrusion molding). Patent Literature 2 fails to describe high solvent solubility, low solution viscosity, or thermal expansion for the coating and molding of the invention. Patent Literature 2 also fails to describe a polycarbonate resin into which a thermosetting group is introduced.

Patent Literature 3 describes that a polycarbonate resin having cyclohexyl groups at ortho positions of bisphenol can be used as a film. However, Patent Literature 3 is an invention relating to a film intended for use in parts and coatings of electronic and electric devices, which is different from the object of the invention. In addition, Patent Literature 3 describes neither dielectric properties nor thermal expansion coefficient.

CITATION LIST

PATENT LITERATURE(S)

Patent Literature 1: International Publication No. WO 2021/085051
Patent Literature 2: International Publication No. WO 2021/039970
Patent Literature 3: JPH01-201329 A


SUMMARY OF THE INVENTION

PROBLEM(S) TO BE SOLVED BY THE INVENTION

An object of the invention is to provide an electronic substrate material having low dielectric properties.

MEANS FOR SOLVING THE PROBLEM(S)

As a result of extensive research, the inventors have found out that an electronic substrate material containing a resin having a specific structural unit is excellent in low dielectric properties. The inventors have also found out a method for synthesizing a resin having a specific structural unit that allows a terminal hydroxyl group content to be controlled at a low level.

That is, the gist of the invention lies in [Configuration 1] to [Configuration 19] as below.

[Configuration 1] An electronic substrate material containing a resin having a structure represented by a formula (UN1) below.

[Formula 1]

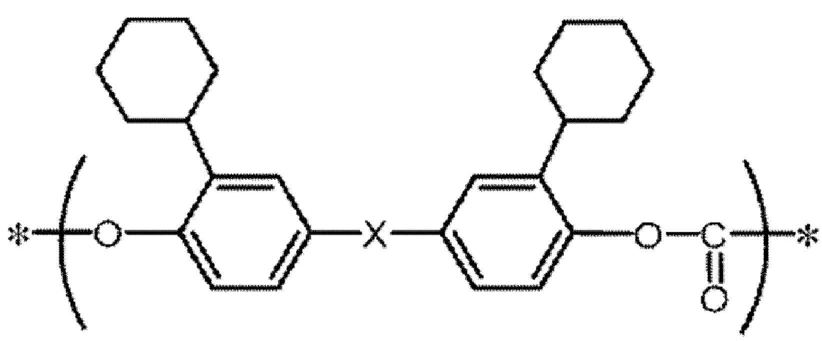

(UN1)

In the formula, X represents a single bond, -O-, -S-, -SO-, $-SO_2-$, or an organic group having 1 to 20 carbon atoms. * each represent a bond.

[Configuration 2] In the electronic substrate material according to Configuration 1, the resin has at least one structure selected from the group consisting of a structure represented by a formula (UN1-1) and a structure represented by a formula (UN1-2). * each represent a bond.

[Formula 2]

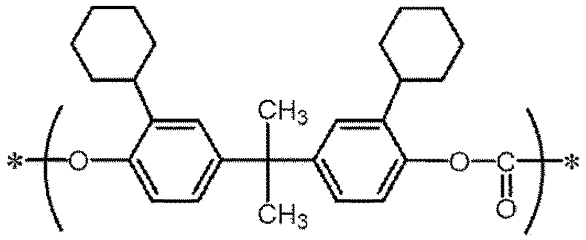

(UN1-1)

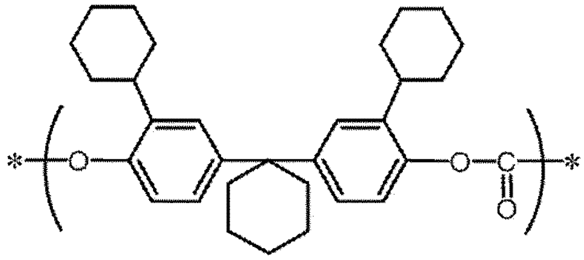

(UN1-2)

[Configuration 3] In the electronic substrate material according to Configuration 1 or Configuration 2, the resin further has at least one structure selected from the group consisting of a structure represented by a formula (UN2), a structure represented by a formula (UN3), a structure represented by a formula (UN4), and a structure represented by a formula (UN5).

[Formula 3]

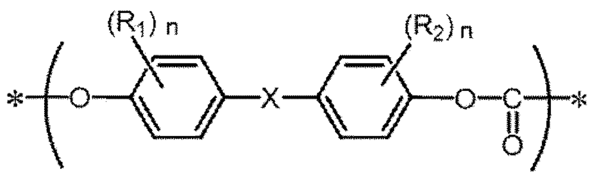

(UN2)

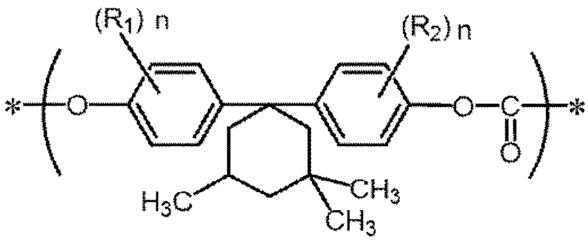

(UN3)

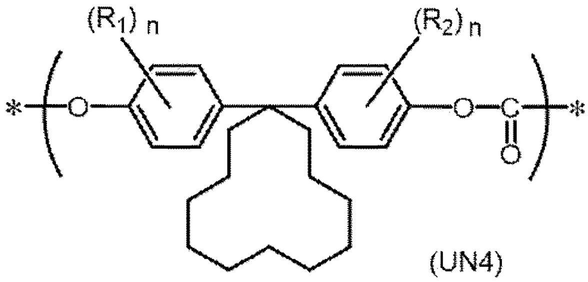

(UN4)

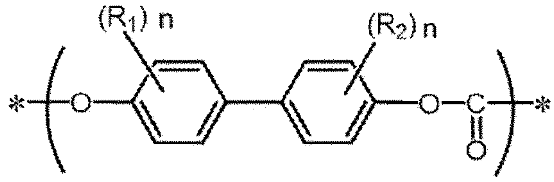

(UN5)

In the formulae:

$R^1$ and $R^2$ each independently represent at least one selected from the group consisting of a halogen atom and an organic group having 1 to 12 carbon atoms, and n represents 0, 1, 2, 3, or 4; at least one $R^1$ and at least one $R^2$ present when a sum of two n is 2 or more may be an identical group or mutually different groups;
X represents a single bond, -O-, -S-, -SO-, $-SO_2-$, or an organic group having 1 to 20 carbon atoms; and
* each represent a bond.

[Configuration 4] In the electronic substrate material according to any of Configuration 1 to Configuration 3, a viscosity-average molecular weight (Mv) of the resin is in a range from 1,000 to 30,000.

[Configuration 5] In the electronic substrate material according to any of Configuration 1 to Configuration 4, a dielectric constant at a frequency of 10 GHz measured according to a split cylinder resonator perturbation method is 2.6 or less.

[Configuration 6] In the electronic substrate material according to any of Configuration 1 to Configuration 5, a dissipation factor at a frequency of 10 GHz measured according to a split cylinder resonator perturbation method is 0.002 or less.

[Configuration 7] In the electronic substrate material according to any of Configuration 1 to Configuration 6, in a case where a dielectric constant and a dissipation factor are measured in a temperature range from 30 degrees C to 150 degrees C or in a range from a temperature of 30 degrees C to a glass transition temperature of the resin according to a split cylinder resonator perturbation method, an amount of change of the dielectric constant is 0.03 or less, and an amount of change of the dissipation factor is 0.005 or less.

[Configuration 8] In the electronic substrate material according to any of Configuration 1 to Configuration 7, a thermal expansion coefficient of the resin in a temperature range from 40 degrees C to 100 degrees C is 100 ppm/K or less.

[Configuration 9] In the electronic substrate material according to any of Configuration 1 to Configuration 8, the resin has a crosslinking structure.

[Configuration 10] In the electronic substrate material according to Configuration 9, the resin has a bond between polymer chains formed by a Diels-Alder reaction.

[Configuration 11] The electronic substrate material according to any of Configuration 1 to Configuration 10 further contains an inorganic filler.

[Configuration 12] The electronic substrate material according to any of Configuration 1 to Configuration 11 further contains a non-halogenated solvent.

[Configuration 13] A film containing the electronic substrate material according to any of Configuration 1 to Configuration 12.

[Configuration 14] A sheet containing the electronic substrate material according to any of Configuration 1 to Configuration 12.

[Configuration 15] An electronic substrate containing the electronic substrate material according to any of Configuration 1 to Configuration 12.

[Configuration 16] A resin having a structure represented by a formula (UN1), a terminal hydroxyl group content of the resin being 6,000 ppm by mass or less.

[Formula 4]

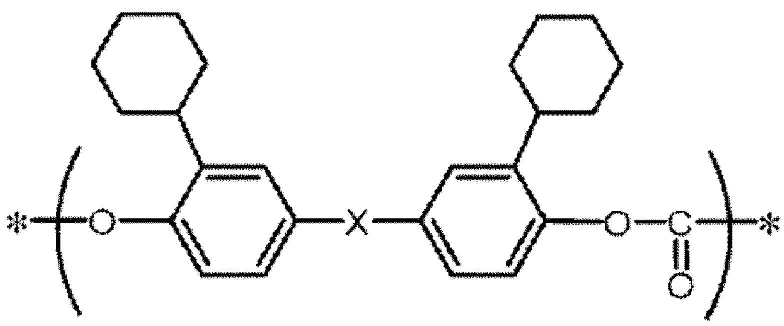

(UN1)

In the formula, X represents a single bond, -O-, -S-, -SO-, $-SO_2-$, or an organic group having 1 to 20 carbon atoms. * each represent a bond.

[Configuration 17] The resin according to Configuration 16 has at least one structure selected from the group consisting of a structure represented by a formula (UN1-1) and a structure represented by a formula (UN1-2). * each represent a bond.

[Formula 5]

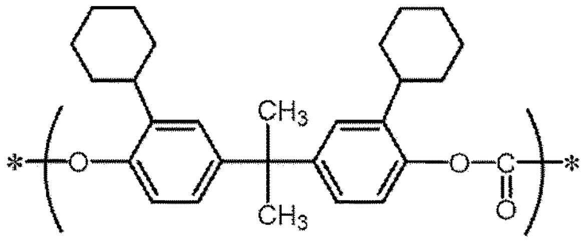

(UN1-1)

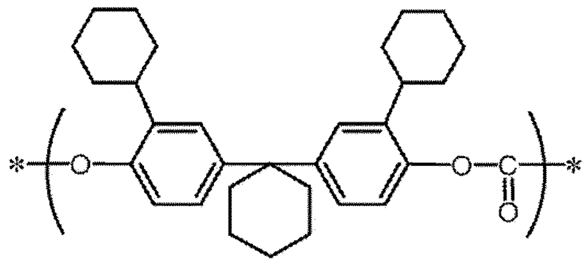

(UN1-2)

[Configuration 18] A method of producing a resin having a structure represented by a formula (UN1), the method including reacting a bischloroformate monomer or oligomer having the structure represented by the formula (UN1) with a bisphenol compound by interfacial polycondensation.

[Formula 6]

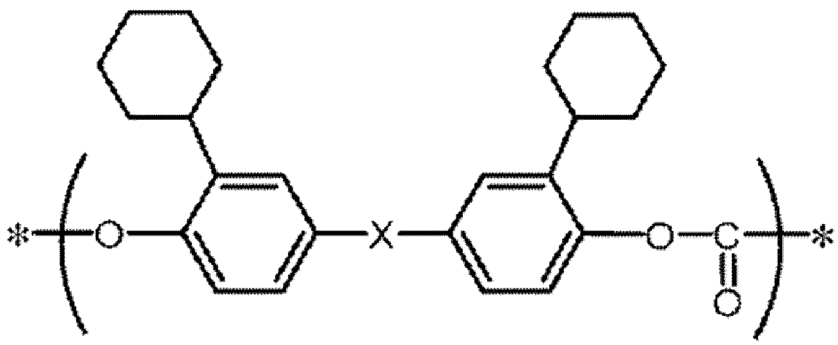

(UN1)

In the formula, X represents a single bond, -O-, -S-, -SO-, $-SO_2-$, or an organic group having 1 to 20 carbon atoms. * each represent a bond.

[Configuration 19] In the method of producing a resin according to Configuration 18, a terminal hydroxyl group content of the resin having the structure represented by the formula (UN1) is 6,000 ppm by mass or less.

[Formula 7]

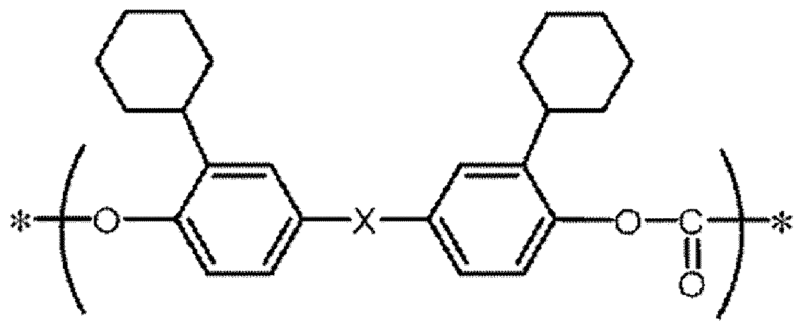

(UN1)

In the formula, X represents a single bond, -O-, -S-, -SO-, $-SO_2-$, or an organic group having 1 to 20 carbon atoms. * each represent a bond.

According to an aspect of the invention, it is possible to provide an electronic substrate material having low dielectric properties.

BRIEF EXPLANATION OF DRAWINGS

Fig. 1 is a graph representing a relationship between temperature and dielectric constant (Dk) in samples obtained in Examples 1 to 4, 7 and 8 and Comparatives 1 and 2.

Fig. 2 is a graph representing a relationship between temperature and dissipation factor (Df) in samples obtained in Examples 1 to 4, 7 and 8 and Comparatives 1 and 2.

DESCRIPTION OF EMBODIMENT(S)

The invention will be described below in detail.

Resin

An electronic substrate material according to an exemplary embodiment contains a resin according to the exemplary embodiment.

The resin according to the exemplary embodiment (polycarbonate resin) relates to a resin having a structure represented by a formula (UN1) below.

[Formula 8]

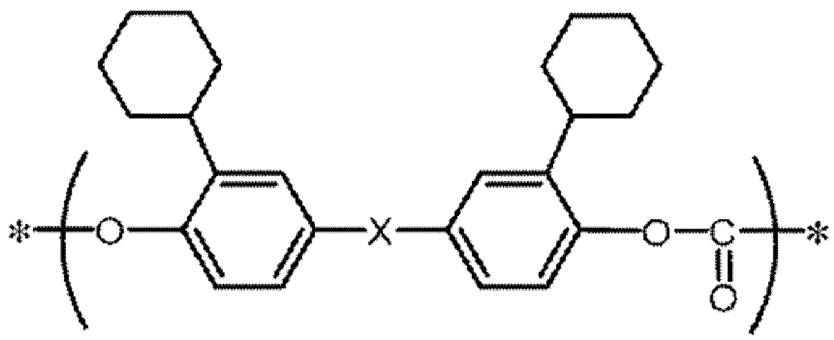

(UN1)

In the formula (UN1):

X is a single bond or a linking group, and X serving as the linking group is - O-, -S-, -SO-, $-SO_2-$, or an organic group having 1 to 20 carbon atoms;

the organic group having 1 to 20 carbon atoms is at least one selected from the group consisting of $-CR^{11}R^{12}-$, a substituted or unsubstituted cycloalkylidene group having 5 to 20 carbon atoms, a substituted or unsubstituted bicyclohydrocarbon diyl group having 5 to 20 carbon atoms, a substituted or unsubstituted tricyclohydrocarbon diyl group having 5 to 20 carbon atoms, a substituted or unsubstituted alkylene group having 2 to 12 carbon atoms, and a substituted or unsubstituted arylene group having 6 to 12 carbon atoms,

$R^{11}$ and $R^{12}$ are each independently at least one selected from the group consisting of a hydrogen atom, a substituted or unsubstituted alkyl group having 1 to 12 carbon atoms, and a substituted or unsubstituted aryl group having 6 to 12 carbon atoms;

the alkyl groups of $R^{11}$ and $R^{12}$ may be bonded to each other to form a ring represented by a formula (RIN1) below; and

* each represent a bond.

[Formula 9]

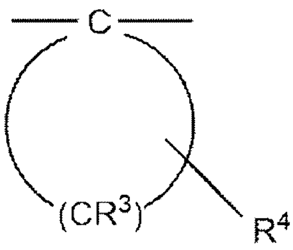

(RIN1)

In the formula (RIN1):

$R^3$ is a substituted or unsubstituted alkyl group having 1 to 12 carbon atoms;
$R^4$ is at least one selected from the group consisting of a hydrogen atom, a substituted or unsubstituted alkyl group having 1 to 12 carbon atoms, a substituted or unsubstituted aryl group having 6 to 12 carbon atoms, and a substituted or unsubstituted cycloalkyl group having 3 to 6 carbon atoms; and
a plurality of $R^4$ may be added to one ring, and in this case, the plurality of $R^4$ may be an identical group or mutually different groups.

The polycarbonate resin according to the exemplary embodiment preferably has at least one structure selected from the group consisting of a structure represented by a formula (UN1-1) and a structure represented by a formula (UN1-2). In the formulae, * each represent a bond.

Exemplary compounds (monomer compounds) that induce a structure represented by the formula (UN1) include 1,1-bis(3-cyclohexyl-4-hydroxyphenyl)cyclohexane, 1,1-bis(3-cyclohexyl-4-hydroxyphenyl)propane, 1,1-bis(3-cyclohexyl-4-hydroxyphenyl)cyclopentane, 1,1-bis(3-cyclohexyl-4-hydroxyphenyl)methane, 1,1-bis(3-cyclohexyl-4-hydroxyphenyl)ethane, 1,1-bis(3-cyclohexyl-4-hydroxyphenyl)-1-phenylethane, and 1,1-bis(3-cyclohexyl-4-hydroxyphenyl)adamantane. These compounds are commercially available or can be synthesized by acid-catalyzed dehydration condensation of the corresponding phenol and ketone.

[Formula 10]

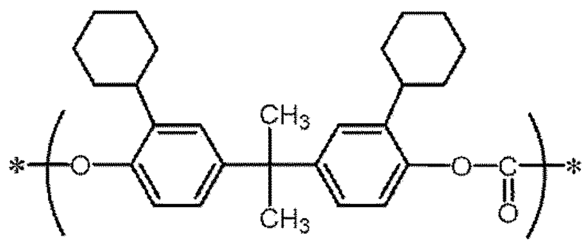

(UN1-1)

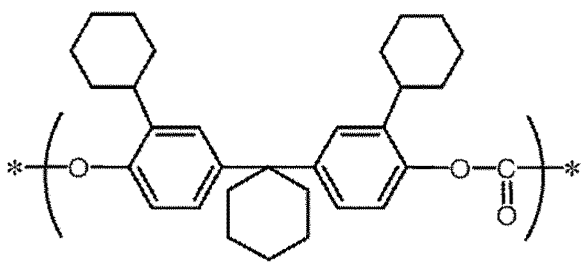

(UN1-2)

Preferably, the polycarbonate resin according to the exemplary embodiment further has a structure represented by a formula (UN3) below in light of the dielectric properties.

[Formula 11]

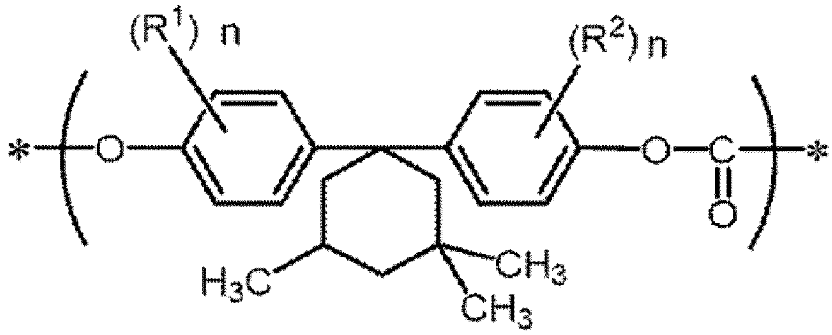

(UN3)

In the formula (UN3):

$R^1$ and $R^2$ each independently represent at least one selected from the group consisting of a halogen atom and an organic group having 1 to 12 carbon atoms;
the organic group having 1 to 12 carbon atoms is at least one selected from the group consisting of an alkyl group having 1 to 12 carbon atoms, a substituted or unsubstituted aryl group having 6 to 12 carbon atoms, an alkoxy group having 1 to 12 carbon atoms, and a substituted or unsubstituted aryloxy group having 6 to 12 carbon atoms;
n represents 0, 1, 2, 3, or 4;
at least one $R^1$ and at least one $R^2$ present when a sum of two n is 2 or more may be an identical group or mutually different groups;
when a plurality of $R^1$ or a plurality of $R^2$ are present, the plurality of $R^1$ may be an identical group or mutually different groups, and the plurality of $R^2$ may be an identical group or mutually different groups; and
* each represent a bond.

Examples of the halogen atom include a fluorine atom, chlorine atom, bromine atom, and iodine atom.
Examples of the alkyl group having 1 to 12 carbon atoms include a methyl group, ethyl group, propyl group, isopropyl group, butyl group, sec-butyl group, tert-butyl group, pentyl group, cyclohexyl group, and trifluoromethyl group.
Examples of the substituted or unsubstituted aryl group having 6 to 12 carbon atoms include a phenyl group, 2-methylphenyl group, 3-methylphenyl group, 4-methylphenyl group, 4-ethylphenyl group, biphenyl group, dichlorophenyl group, naphthyl group, and methylnaphthyl group.
Examples of the alkoxy group having 1 to 12 carbon atoms include a methoxy group, ethoxy group, propoxy group, isopropoxy group, butoxy group, isobutoxy group, sec-butoxy group, tert-butoxy group, various pentyloxy groups, and various hexyloxy groups.
Examples of the substituted or unsubstituted aryloxy group having 6 to 12 carbon atoms include a phenoxy group, tolyloxy group, and naphthyloxy group.
The presence of a substituent in $R^1$ and $R^2$ can reduce the molecular mobility of a carbonate group due to its steric hindrance, which is favorable because the dissipation factor lowers. In order to lower the dielectric constant, it is necessary to lower the density and the polarity. The presence of a substituent in $R^1$ and $R^2$ makes it difficult to cause the packing of polymer chains, thereby reducing density, or when the substituent is a low-polarity group, the concentration of a carbonate group, which is a polar group in polycarbonate, is decreased to thereby reduce the polarity of the entire polymer. Therefore, in order to lower the dielectric constant, a substituent having low polarity and large volume is preferable.
Exemplary compounds (monomer compounds) that induce a structure represented by the formula (UN3) include 1,1-bis(4-hydroxyphenyl)-3,3,5-trimethylcyclohexane, 1,1-bis(4-hydroxy-3-methylphenyl)-3,3,5-trimethylcyclohexane, and 1,1-bis(4-hydroxy-3,5-dimethylphenyl)-3,3,5-trimethylcyclohexane. These compounds are commercially available or can be synthesized by acid-catalyzed dehydration condensation of the corresponding phenol and ketone.
Preferably, the polycarbonate resin according to the exemplary embodiment further has a structure represented by a formula (UN4) below in light of the dielectric properties.

[Formula 12]

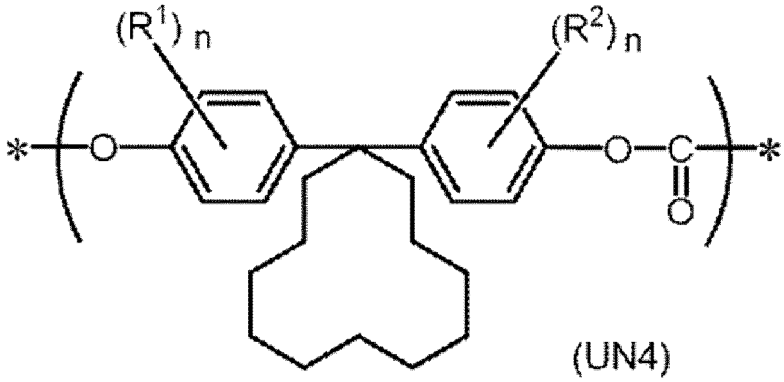

(UN4)

In the formula (UN4):

$R^1$ and $R^2$ are as defined above;
n is as defined above; and
* each represent a bond.

Exemplary compounds (monomer compounds) that induce a structure represented by the formula (UN4) include 1,1-bis(4-hydroxyphenyl)cyclododecane, 1,1-bis(4-hydroxy-3-methylphenyl)cyclododecane, and 1,1-bis(4-hydroxy-3,5-dimethylphenyl)cyclododecane. These compounds are commercially available or can be synthesized by acid-catalyzed dehydration condensation of the corresponding phenol and ketone.

Preferably, the polycarbonate resin according to the exemplary embodiment further has a structure represented by a formula (UN5) below in light of the dielectric properties.

[Formula 13]

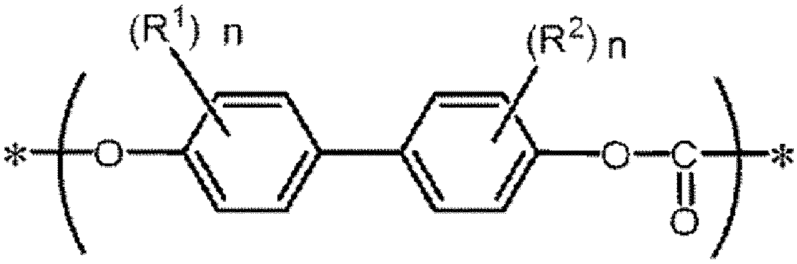

(UN5)

In the formula (UN5):

$R^1$ and $R^2$ are as defined above;
n is as defined above; and
* each represent a bond.

Exemplary compounds having a structure represented by the formula (UN5) include 2,2-dimethyl-4,4-biphenol, 2,2,6,6-tetramethyl-4,4-biphenol, and 2,2,3,3,6,6-hexamethyl-4,4-biphenol. These compounds are commercially available or can be synthesized by acid-catalyzed dehydration condensation of the corresponding phenol and ketone.

The polycarbonate resin according to the exemplary embodiment may further have a structure represented by a formula (UN2) below.

[Formula 14]

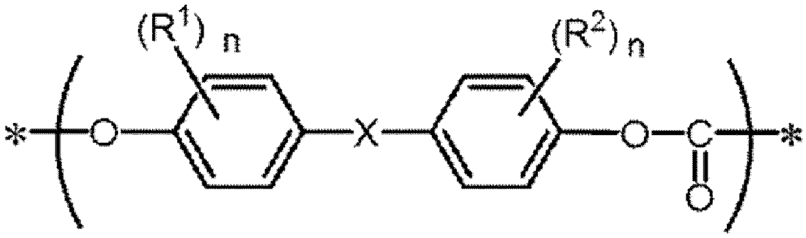

(UN2)

In the formula (UN2):

$R^1$ and $R^2$ are as defined above;
n is as defined above;
X is as defined above; and
* each represent a bond.

Exemplary compounds (monomer compounds) that induce a structure represented by the formula (UN2) include 2,2-bis(4-hydroxy-3-isopropylphenyl)propane, and 1,1-bis(4-hydroxyphenyl)cyclohexane. These compounds are commercially available or can be synthesized by acid-catalyzed dehydration condensation of the corresponding phenol and ketone.

Preferably, the polycarbonate resin according to the exemplary embodiment further has at least one structure selected from the group consisting of a structure represented by the formula (UN2), a structure represented by the formula (UN3), a structure represented by the formula (UN4), and a structure represented by the formula (UN5).

There are various methods for evaluating dielectric properties. A commonly used method is a cavity resonator perturbation method (hereinafter referred to as a cavity resonator method), which uses an electric field aligned with a sample to evaluate the dielectric properties. However, the electric field deflects to the outside of the sample at both ends of the sample. Since there is no known quantitative explanation for the imperfection, the dielectric constant is typically calculated by assuming that the electric field passes through the entire sample. Therefore, values of the dielectric properties are calculated assuming that the electric field is applied to the entire sample, even though no electric field is applied to either end of the sample. The dielectric constant is thus measured to be low. Unlike the cavity resonance method, a split cylinder resonator perturbation method (hereinafter referred to as a split cylinder method), which uses a circular electric field along a sample surface for measurement, does not cause errors due to the deflection of the electric field at both ends of the sample. Therefore, the split cylinder method outputs a dielectric property value closer to the true value than the cavity resonance method.

In the polycarbonate resin according to the exemplary embodiment, the dielectric constant (Dk) measured at room temperature and a frequency of 10 GHz using a split cylinder resonator is preferably 2.6 or less, more preferably 2.55 or less, and still more preferably 2.5 or less. The dissipation factor (Df) measured at room temperature and a frequency of 10 GHz using a split cylinder resonator is preferably 0.003 or less, more preferably 0.002 or less, and still more preferably 0.001 or less. Setting the dielectric constant and dissipation factor to equal to or less than the above upper limits reduces the loss of electrical signals in the electronic substrate, which is favorable. In addition, consider a case where the resin according to the exemplary embodiment is used as an electronic substrate material. Since the electronic substrate has a high temperature during use, it is also important that the dielectric constant or dissipation factor is low at a high temperature.

Furthermore, in a case where the dielectric constant and the dissipation factor of the resin are measured in a temperature range from 30 degrees C to 150 degrees C or in a range from a temperature of 30 degrees C to a glass transition temperature of the resin according to the split cylinder resonator perturbation method, an amount of change of the dielectric constant is preferably 0.03 or less, and an amount of change of the dissipation factor is preferably 0.005 or less.

In the polycarbonate resin according to the exemplary embodiment, when the total of the constituent units is taken as 100 mol%, the proportion of the formula (UN1) is preferably 40 mol% or more, more preferably 50 mol% or more, still more preferably 55 mol% or more, and still further more preferably 60 mol% or more. When the proportion of the formula (UN1) is 40 mol% or more, the dielectric properties or heat resistance is more excellent. In addition, the proportion of the formula (UN1) may be 99 mol% or less, 90 mol% or less, or 80 mol% or less. The proportion of the formula (UN1) is

preferably in a range from 40 mol% to 99 mol%, more preferably in a range from 55 mol% to 90 mol%. The constituent unit herein means a unit sandwiched between two carbonate bonds to form a main chain together with the two carbonate bonds.

A polycarbonate resin with a viscosity-average molecular weight of 30,000 or less is easily soluble in non-halogenated solvents and has low viscosity, and thus is easy to handle in coating and molding, or to disperse with fillers or other thermosetting materials. Such a polycarbonate resin is excellent in versatility as the electronic substrate material.

In view of the above, the viscosity-average molecular weight (Mv) of the polycarbonate resin according to the exemplary embodiment is preferably in a range from 1,000 to 30,000, more preferably in a range from 1,000 to 26,000, still more preferably in a range from 1,000 to 22,000, still further more preferably in a range from 1,000 to 19,000, yet still further more preferably in a range from 1,000 to 18,000, and most preferably in a range from 1,000 to 17,500.

In addition, since the polycarbonate resin according to the exemplary embodiment preferably has a low thermal expansion coefficient, the thermal expansion coefficient in a temperature range from 40 degrees C to 100 degrees C is preferably 100 ppm/K or less.

A thermosetting group (crosslinking group) can also be introduced into a structure of the polycarbonate resin according to the exemplary embodiment. The resin that contains this crosslinking group structure, i.e., has a crosslinking structure, is called a thermosetting resin. By changing from the thermoplastic resin to the thermosetting resin, the heat resistance and elastic modulus can be improved. Processing or solder reflow for using the resin as the electronic substrate material generates high temperatures, and the temperature also increases when a molded product with a built-in electronic substrate is used. The use of the thermosetting resin with high heat resistance and elastic modulus prevents the resin from flowing or the electronic substrate from deforming.

The crosslinking group of the thermosetting resin is exemplified by epoxy, allyl, maleimide, oxazole, cyclobutene, isocyanate, and cyanate ester.

For instance, a conjugated diene structure or conjugated diene group (hereinafter, these may be simply referred to as "conjugated diene") having a bond between polymer chains by a Diels-Alder reaction may be applied. The conjugated diene preferably has at least one of a structure represented by a formula (UN6) below or a structure represented by a formula (UN7) below. Alternatively, as represented by formulae (UN8), (UN9) and (UN10) below, it is allowable to use a Diels-Alder reaction in which a conjugated diene structure is introduced into terminals of polymer chains to bond the terminals of the polymer chains together.

[Formula 15]

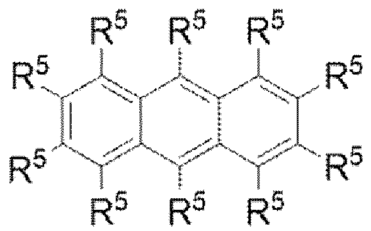

(UN6)

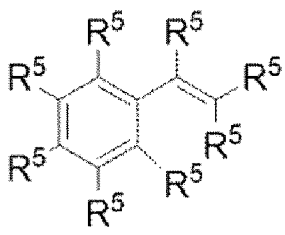

(UN7)

In the formulae (UN6) and (UN7):

each $R^5$ is independently a single bond, a bonding group to another skeleton, a hydrogen atom, an aliphatic hydrocarbon group having 1 to 12 carbon atoms, an aromatic hydrocarbon group having 6 to 12 ring carbon atoms, or an alkoxy group having 1 to 10 carbon atoms; and
one or two of $R^5$ are a single bond or a linking group to another skeleton, and
$R^5$ serving as the linking group is a group which contains at least one atom selected from the group consisting of a carbon atom, an oxygen atom, a nitrogen atom, a sulfur atom, a silicon atom, a phosphorus atom, and a boron atom and in which bonding forms between atoms constituting the linking group are each a covalent bond.

A plurality of $R^5$ may be linked together to form a cyclic structure (including an aromatic ring and a heterocycle).

[Formula 16]

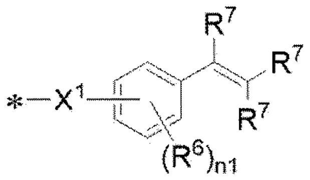

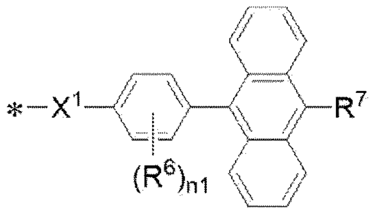

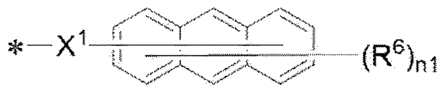

(UN8) (UN9) (UN10)

In the formulae (UN8) to (UN10):

each $X^1$ is independently -O-, -(C=O)-O-, -O-(C=O)-O-, or -O-(C=O)-;
each $R^6$ is independently an aliphatic hydrocarbon group having 1 to 10 carbon atoms, an aromatic hydrocarbon group having 6 to 12 ring carbon atoms, or an alkoxy group having 1 to 10 carbon atoms;
a plurality of $R^6$ may be linked together to form a cyclic structure (including an aromatic ring and a heterocycle);
each $R^7$ is independently a hydrogen atom, an aliphatic hydrocarbon group having 1 to 12 carbon atoms, or an aromatic hydrocarbon group having 6 to 12 carbon atoms;
n1 represents 0 or a natural number whose upper limit is the number of substitutable positions; and
* each represent a bond.

The crosslinking group of the thermosetting resin of the invention is exemplified by an allyl structure or an allyl group having, for instance, a bond between polymer chains by an ene reaction. The allyl structure preferably includes at least one of a structure represented by a formula (UN11), a structure represented by a formula (UN12), or a structure represented by a formula (UN13) below because of its high reactivity. The allyl structure represented by the formula (UN11) has two allyl groups. In the allyl structure represented by the formula (UN12) or the formula (UN13), an allyl group is introduced into polymer terminals, and an ene reaction proceeds at the terminals of the polymer chains.

[Formula 17]

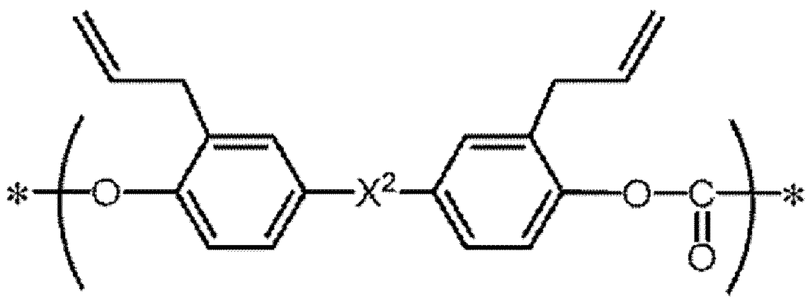

(UN11)

[Formula 18]

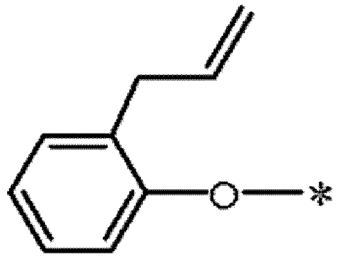

(UN12)

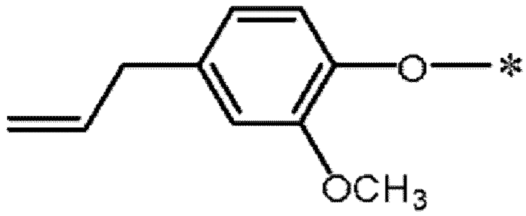

(UN13)

In the formulae (UN11), (UN12), and (UN13):

$X_2$ is at least one selected from the group consisting of -O-, -S-, -SO-, $-SO_2-$, $-CR^{11}R^{12}-$, a substituted or unsubstituted cycloalkylidene group having 5 to 20 carbon atoms, a substituted or unsubstituted bicyclohydrocarbon diyl group having 5 to 20 carbon atoms, a substituted or unsubstituted tricyclohydrocarbon diyl group having 5 to 20 carbon atoms, a substituted or unsubstituted alkylene group having 2 to 12 carbon atoms, and a substituted or unsubstituted arylene group having 6 to 12 carbon atoms;
$R^{11}$ and $R^{12}$ are as defined above; and
* each represent a bond.

The content of the crosslinking groups having a conjugated diene structure or allyl structure in the polycarbonate resin can be appropriately set depending on the desired physical properties or intended applications. Considering use as the electronic substrate material, the effects of improving heat resistance and decreasing thermal expansion coefficient are noticeable when the proportion of crosslinking groups is 10 mol% or more when the total of the constituent units is taken as 100 mol%.

The polycarbonate resin according to the exemplary embodiment can be produced by a conventional polymerization process such as interfacial polycondensation or melt transesterification.

The interfacial polycondensation is a process for obtaining a polycarbonate resin by converting a monomer such as a bisphenol compound into an alkaline salt in the presence of an organic solvent inert to the reaction and an alkaline aqueous solution, and then polycondensing phosgene or a compound capable of forming a carbonate bond at the interface. The melt transesterification involves, for instance, a transesterification reaction of carbonate ester with a monomer such as bisphenol or a diol compound.

The polycarbonate resin in the exemplary embodiment preferably has a low terminal hydroxyl group content. The terminal hydroxyl group content refers to hydroxyl groups derived from remaining bisphenols and hydroxyl groups derived from polymer terminals. As the terminal hydroxyl group content increases, the low dielectric properties tend to deteriorate because the structure with higher polarity increases the dielectric constant according to the Clausius-Mossotti equation. In addition, highly polar groups tend to increase the dissipation factor. Thus, in order to achieve low dielectric properties and inhibit the variation in properties, it is necessary to control the terminal hydroxyl group content.

From this perspective, the polycarbonate resin according to the exemplary embodiment preferably has a terminal hydroxyl group content of 6,000 ppm by mass or less. The terminal hydroxyl group content may be 3,000 ppm by mass or less, 1,000 ppm by mass or less, 900 ppm by mass or less, 800 ppm by mass or less, 700 ppm by mass or less, 600 ppm by mass or less, 500 ppm by mass or less, 400 ppm by mass or less, 300 ppm by mass or less, 208 ppm by mass or less, 200 ppm by mass or less, 100 ppm by mass or less, or 50 ppm by mass or less.

To calculate the terminal hydroxyl group content, the molar ratio of each structure (each constituent unit) of polycarbonate is first calculated using NMR. Each structure refers to a main structure, a sub structure, a terminal capping agent structure, or a hydroxyl group terminal structure. Examples of the terminal capping agent structure include a PTBP terminal (formula (UN14)) and a diethylamine terminal (formula (UN15)). Examples of the hydroxyl group terminal structure include a hydroxyl group terminal structure derived from a bisphenol (formula (UN16)). Since the interfacial polycondensation is used in the exemplary embodiment, the polycarbonates produced include a diethylamine terminated polycarbonate derived from catalytic triethylamine. The weight ratio is calculated from the calculated molar ratio and the molecular weight of each structure, and the hydroxyl group amount in the total weight of the polymer is calculated in ppm by mass.

[Formula 19]

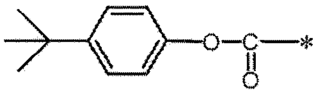

(UN14)

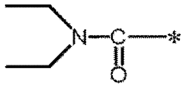

(UN15)

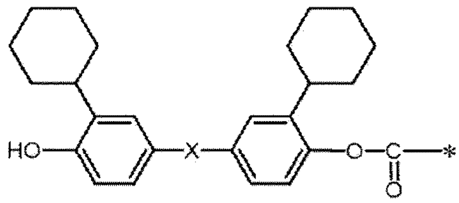

(UN16)

Existing producing methods are broadly divided into two types: interfacial polycondensation and melt transesterification. The interfacial polycondensation is known to be suitable for reducing the terminal hydroxyl group content. However, the terminal hydroxyl group content could not be sufficiently reduced in some cases when the polycarbonate resin according to the exemplary embodiment was produced by interfacial polycondensation.

The inventors have conducted extensive research to reduce the terminal hydroxyl group content, and found out two methods. The first method is to control a ratio of bisphenol/chloroformate group. The bisphenol and chloroformate group are in a molar ratio.

Since this reaction is a condensation reaction, if there is a large difference in the ratio of the two types of reaction active groups, the reaction active group with a larger ratio will tend to remain at polymer chain terminals. It is therefore important to control the ratio between the reaction active groups. Thus, it is necessary to control the ratio between chloroformate and bisphenol in this reaction, and controlling this ratio can reduce the amount of the terminal hydroxyl group, which is a polar group. The exact amount of chloroformate can be determined most effectively by synthesizing bisphenol and phosgene to obtain an oligomer, isolating the oligomer, and then precisely quantifying the concentration of the chloroformate group. In the invention, it has been found out that the amount of the terminal hydroxyl group in the polymer can be controlled to an extremely low level by reacting a proper amount of bisphenol to the amount of chloroformate in the oligomer.

The ratio between the chloroformate group and the bisphenol needs to be appropriately set depending on the properties derived from the structure of the monomer used. The bisphenol/chloroformate ratio can be set in a range from 0.5 to 1.1, preferably in a range from 0.6 to 1.0, and more preferably in a range from 0.7 to 0.9. If the bisphenol/chloroformate ratio is greater than 1.1, the terminal hydroxyl group is likely to remain, and if the bisphenol/chloroformate ratio is 0.5 or less, chloroformate is likely to remain.

Consider a case of bisphenols with cyclohexyl groups at ortho positions. Some bisphenols have substituents adjacent to phenolic hydroxyl groups, which reduces the hydrophilic atmosphere around the phenolic hydroxyl groups. Thus, such bisphenols become more soluble in methylene chloride, which is a reaction solvent, than regular bisphenols. In a typical polymer elongation reaction, the alkoxy groups at the polymer terminals generated by the reaction are present at the interface, and react with chloroformates in the methylene chloride layer to produce polymers. In relation to the above, the inventors have found out as follows. When the above bisphenol having good solubility in methylene chloride is used in the reaction, a small amount of terminal polymers with hydroxyl groups, which have been converted from alkoxy groups at polymer terminals in an equilibrium reaction, dissolve in the methylene chloride. Before the hydroxyl-terminated polymers that have migrated to the organic layer are alkoxylated again and the polymerization reaction proceeds, the reaction with chloroformates, which are counterpart active groups, is completed. The hydroxyl groups are thus likely to remain at the terminals of the polymers. In order to reduce such hydroxyl terminals, it is important to control the bisphenol/chloroformate ratio as described above.

The second method for reducing the terminal hydroxyl group content involves reacting a bisphenol with a bischloroformate monomer or oligomer represented by a formula (1A). Converting a bisphenol having cyclohexyl groups at ortho positions into a bischloroformate oligomer eliminates the effect of bisphenol. It is thus possible to reduce the terminal hydroxyl group content without considering the above problem.

[Formula 20]

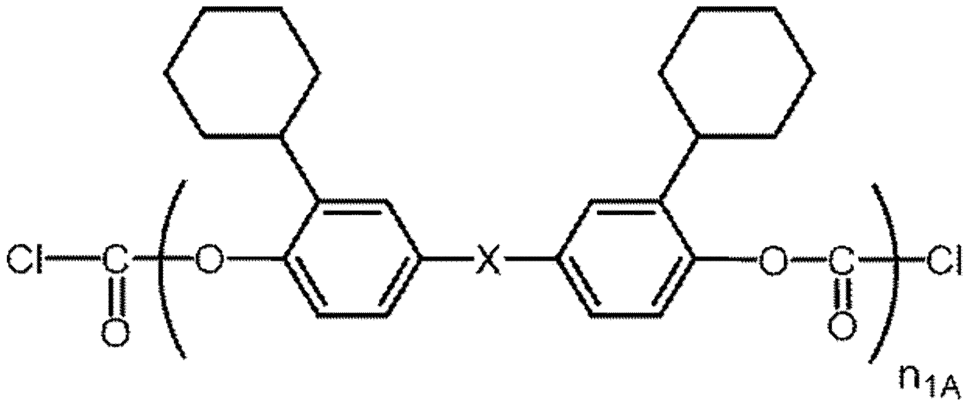

(1A)

In the formula (1A):
$n_{1A}$ represents an average number of repeating units, and the average number of repeating units $n_{1A}$ is in a range from 1.0 to 10.

The resulting polycarbonate resin may be any copolymer such as a block copolymer, an alternating copolymer, or a random copolymer.

The reason why the monomer ($n_{1A}$ = 1.0) is preferred is that the copolymerization ratio can be adjusted in a wide range. In particular, consider a case where the molecular weight of copolymerized monomers is low. If the number of repeating units of the oligomer (1A) is high, the composition of the corresponding one to be copolymerized therewith is low. Furthermore, the molecular weight itself is easy to control. In a case where the corresponding one to be copolymerized therewith is easily crystallized, a decrease in solubility can be prevented.

Consider a case where a polycarbonate resin having a bisphenol with cyclohexyl groups at ortho positions of the formula (UN1) that exhibits low dielectric properties is produced. If a bisphenol having such a skeleton is used, its solubility in an alkaline aqueous solution is poorer than that of ordinary bisphenols due to a high acid dissociation constant thereof, and such a bisphenol is only partially soluble in the alkaline aqueous solution at room temperature. Even in this state, the bisphenol is consumed as the polymerization reaction proceeds and the reaction continues as a previously insoluble bisphenol becomes newly dissolve. However, in such a state, only one of the two hydroxyl groups of the bisphenol is ionized as a phenolate and participates in the reaction. The resulting polymer thus has many residual hydroxyl groups at its terminals. This problem also is solved by converting a bisphenol having cyclohexyl groups at ortho positions into a bischloroformate oligomer to eliminate the effect of bisphenol. It is thus possible to reduce the terminal hydroxyl group content without considering the above problem.

In the interfacial polycondensation, a monovalent carboxylic acid or a derivative thereof, or a monovalent phenol can be used as a terminal capping agent for generating a chain terminal.

Preferred examples thereof include p-tert-butylphenol, p-phenylphenol, p-cumylphenol, p-perfluorononylphenol, p-(perfluorononylphenyl)phenol, p-(perfluorohexyl)phenol, p-tert-perfluorobutylphenol, p-perfluorooctylphenol, 1-(p-hydroxybenzyl)perfluorodecane, p-[2-(1H,1H-perfluorotridodecyloxy)-1,1,1,3,3,3-hexafluoropropyl]phenol, 3,5-bis(perfluorohexyloxycarbonyl)phenol, perfluorododecyl p-hydroxybenzoate, p-(1H,1H-perfluorooctyloxy)phenol, and 2H,2H,9H-perfluorononanoic acid.

Exemplary acid-binding agents for the interfacial polycondensation include alkali metal hydroxides such as sodium hydroxide, potassium hydroxide, lithium hydroxide, and cesium hydroxide; alkaline earth metal hydroxides such as magnesium hydroxide and calcium hydroxide; weak alkali metal acid salts such as sodium carbonate and potassium carbonate; weak alkaline earth metal acid salts such as calcium acetate; and organic bases such as pyridine. Preferred acid-binding agents for the interfacial polycondensation are alkali metal hydroxides such as sodium hydroxide and potassium hydroxide, as well as alkaline earth metal hydroxides such as calcium hydroxide. These acid-binding agents may also be used as a mixture. The proportion of the acid-binding agent used may be appropriately adjusted taking into consideration the stoichiometric ratio (equivalent) of the reaction. Specifically, the acid-binding agent may be used in an amount of 1 equivalent or in a more excessive amount per 1 mole of the total of hydroxy groups of a divalent phenol serving as a raw material. Preferably, 1 to 10 equivalents of the acid-binding agent may be used.

As the solvent used in the interfacial polycondensation, it is preferable to use an organic solvent that is substantially immiscible with water and that is capable of dissolving the finally obtained polycarbonate copolymer in an amount of 5 mass% or more. The organic solvent is preferably an organic solvent that is substantially immiscible with water and that is capable of dissolving the finally obtained polycarbonate copolymer in an amount of 5 mass% or more.

Herein, the organic solvent that is "substantially immiscible with water" refers to an organic solvent that does not provide a solution having a uniform layer (a solution that is free of either gelled or insoluble matter) when water and the

organic solvent are mixed in a composition range of 1:9 to 9:1 at normal temperatures and pressures.

The organic solvent that is "capable of dissolving the finally obtained polycarbonate copolymer in an amount of 5 mass% or more " refers to a solubility of the polycarbonate copolymer as measured at a temperature of 20 degrees C to 30 degrees C and normal pressure.

The "finally obtained polycarbonate polymer" refers to a polymer obtained through a polymerization step in the method for producing a polycarbonate polymer according to the exemplary embodiment, the polymer before being subjected to cross-linking.

Examples of such an organic solvent include aromatic hydrocarbons such as toluene, ketones such as cyclohexanone, and halogenated hydrocarbons such as methylene chloride. Of these, methylene chloride is preferred because of its high solubility.

The catalyst used in the interfacial polycondensation is not particularly limited, and preferred examples thereof include tertiary amines such as trimethylamine, triethylamine, tributylamine, N,N-dimethylcyclohexylamine, pyridine, N,N-diethylaniline, and N,N-dimethylaniline; quaternary ammonium salts such as trimethylbenzyl ammonium chloride, triethylbenzyl ammonium chloride, tributylbenzyl ammonium chloride, trioctylmethyl ammonium chloride, tetrabutyl ammonium chloride, and tetrabutyl ammonium bromide; and quaternary phosphonium salts such as tetrabutylphosphonium chloride and tetrabutylphosphonium bromide.

Furthermore, a small amount of an antioxidant such as sodium sulfite or a hydrosulfite salt may be added to the reaction system, if necessary.

Resin Precursor Composition

A resin precursor composition according to the exemplary embodiment contains a resin having the above crosslinking group and a corresponding crosslinking agent.

As the crosslinking agent, for instance, in the case of a Diels-Alder reaction or ene reaction, a crosslinking agent having a maleimide skeleton is suitably used because of its high reactivity. Examples of the resin precursor composition include bismaleimides such as 4,4-diphenylmethane bismaleimide, m-phenylene bismaleimide, bisphenol A diphenyl ether bismaleimide, 3,3-dimethyl-5,5-diethyl-4,4-diphenylmethane bismaleimide, 4-methyl-1,3-phenylene bismaleimide, 1,6-bismaleimide-(2,2,4-trimethyl)hexane, 4-diphenylether bismaleimide, 4,4-diphenylsulfone bismaleimide, 1,3-bis(3-maleimidophenoxy)benzene, 1,3-bis(4-maleimidophenoxy)benzene, diphenylmethane-4,4-bismaleimide polymers having 4,4-methylenedianiline, N,N-(2,2-diethyl-6,6-dimethylenediphenylene)bismaleimide, N,N-(4-methyl-m-phenylene) bismaleimide, N,N-m-phenylene dimaleimide, N,N-m-phenylene bismaleimide, and polyphenylmethane bismaleimide, as well as polycarbonate resins in which a molecular terminal is terminated with a compound below.

[Formula 21]

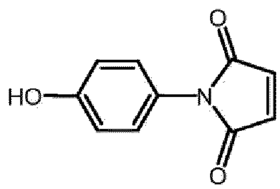

The above crosslinking agents can be appropriately set according to the content of the crosslinking groups having the conjugated diene structure or allyl structure in the polycarbonate resin, or according to the desired physical properties or intended applications.

Coating Liquid Composition

A coating liquid composition (varnish) according to the exemplary embodiment includes an electronic substrate material according to the exemplary embodiment. More specifically, the coating liquid composition (varnish) according to the exemplary embodiment includes a polycarbonate resin or a resin precursor composition according to the exemplary embodiment and an organic solvent.

The organic solvent of the coating liquid composition can be appropriately selected in consideration of the solubility of a material such as a polycarbonate resin or resin precursor composition according to the exemplary embodiment, the drying rate after molding, the effect of a residue on a molded product, and the risk (fire or harmful effect on the health).

Examples of the organic solvent according to the exemplary embodiment include cyclic ethers (such as

tetrahydrofuran (THF), dioxane, and dioxolane), cyclic ketones (such as cyclohexanone, cyclopentanone, and cycloheptanone), aromatic hydrocarbons (such as toluene, xylene, and chlorobenzene), ketones (such as methyl ethyl ketone (MEK) and methyl isobutyl ketone (MIBK)), halogenated hydrocarbons (such as dichloromethane and chloroform), esters (such as ethyl acetate, isopropyl acetate, isobutyl acetate, and butyl acetate), ethers (such as ethylene glycol dimethyl ether and ethylene glycol monoethyl ether), amides (such as N,N-dimethylformamide (DMF) and dimethylacetamide (DMAc), and aprotic polar solvents (such as dimethyl sulfoxide (DMSO)).

Of the above, in consideration of the environment and safety, organic solvents other than halogenated hydrocarbons, that is, non-halogenated solvents, are preferred.

The concentration of the polycarbonate resin or resin precursor composition according to the exemplary embodiment in the coating liquid composition according to the exemplary embodiment is not limited as long as an appropriate viscosity suitable for the usage of the coating liquid composition is achieved, and is preferably in a range from 0.1 mass% to 40 mass%, more preferably in a range from 1 mass% to 35 mass%, and still more preferably in a range from 5 mass% to 30 mass%. At a concentration of 40 mass% or less, the viscosity is not excessively high, and good coatability is achieved. At a concentration of the lower limit or more, a suitable viscosity can be maintained, and a homogenous film is obtained. Furthermore, the concentration is one suitable for reducing the drying time after coating or for easily obtaining a target film thickness.

Electronic Substrate

The electronic substrates can be broadly classified into a semiconductor substrate and an electronic circuit board.

(1) Semiconductor Substrate Material

A substrate on which a wiring layer that performs the input and output of electrical signals to and from chips such as logic ICs, memories, and sensors, and a connection layer for connecting FC-CSP (flip chip chip scale package), FC-BGA (flip chip ball grid array), FO-WLP (fan-out package), or different types of chips in parallel or when stacked are formed.

(2) Electronic Circuit Board

A substrate on which a wiring layer is formed to connect multiple electronic components such as semiconductors or capacitors. Exemplary electronic circuit broads include multilayer boards (rigid or flexible) with stacked wiring.

Electronic Substrate Material

An electronic substrate material according to the exemplary embodiment is used in the form of a film, a sheet, or a coating liquid composition (varnish) to form an electronic substrate according to the exemplary embodiment. That is, these film, sheet, and varnish include an electronic substrate material according to the exemplary embodiment.

The electronic substrate material according to the exemplary embodiment is excellent in low dielectric properties, a low thermal expansion coefficient, and high heat resistance. The electronic substrate material according to the exemplary embodiment can provide a composition for a coating liquid having high solvent solubility or low solution viscosity for coating and molding. The electronic substrate material according to the exemplary embodiment can provide a thermosetting resin by introducing a thermosetting group that improves heat resistance and elastic modulus.

Film

When the electronic substrate material according to the exemplary embodiment is used as a film, it can be made into a film by thermoforming such as melt extrusion, or by solution casting. When a desired film thickness is thin (a few μm to a few tens of μm), the film is preferably formed by solution casting. In addition, for the purpose of reducing thermal expansion, the electronic substrate material according to the exemplary embodiment may be impregnated into glass cloth to form a film or may be formed into a film with an inorganic filler such as silica dispersed therein. When the electronic substrate material according to the exemplary embodiment having a crosslinking site is used to form a film by solution casting, the degree of crosslinking can be controlled by containing a curing material in the electronic substrate material to adjust the heating temperature, whereby the elastic modulus of the film or the like can be changed.

Varnish

The electronic substrate material according to the exemplary embodiment may be applied in a solution state

directly onto a core material or the like made from polyimide, epoxy resin, or the like. In this case also, an inorganic filler such as silica may be dispersed.

Exemplary suitable solvents include toluene, cyclohexanone, and MEK.

Sheet

When the electronic substrate material according to the exemplary embodiment is used as a sheet, it can be made into a sheet by impregnating a base material or the like with the varnish described above.

Examples

Next, the invention will be described in more detail with reference to Examples and Comparatives. However, the invention is not limited to these Examples, and various modifications and applications can be made without departing from the idea of the invention.

Production Examples: Preparation of Oligomer

Production Example 1: Synthesis of 2,2-bis(3-cyclohexyl-4-hydroxyphenyl)propane oligomer (bischloroformate)

In 1,080 mL of methylene chloride, 87.9 g (224 mmol) of 2,2-bis(3-cyclohexyl-4-hydroxyphenyl)propane was suspended, and 66.0 g (667 mmol) of phosgene was added thereto to achieve dissolution. To this, a liquid in which 44.0 g (435 mmol) of triethylamine was dissolved in 120 mL of methylene chloride was added dropwise in a temperature range from 5 degrees C to 15 degrees C. Next, stirring was performed for 30 minutes, and methylene chloride was then distilled off until the concentration thereof reached a predetermined value. To the residual liquid, 210 mL of pure water, 1.2 g of concentrated hydrochloric acid, and 450 mg of hydrosulfite were added, and washing was performed. Subsequently, washing was repeated with 210 mL of pure water five times to obtain a methylene chloride solution of a 2,2-bis(3-cyclohexyl-4-hydroxyphenyl)propane oligomer having chloroformate groups at molecular terminals. The obtained solution had a chloroformate concentration of 0.84 mol/L, a solid concentration of 0.223 kg/L, and an average number of repeating units of 1.03. Hereinafter, this resulting raw material is referred to as CHA-CF.

Production Example 2: Synthesis of 1,1-bis(3-cyclohexyl-4-hydroxyphenyl)cyclohexane oligomer (bischloroformate)

In 1,080 mL of methylene chloride, 96.9 g (224 mmol) of 1,1-bis(3-cyclohexyl-4-hydroxyphenyl)cyclohexane was suspended, and 66.0 g (667 mmol) of phosgene was added thereto to achieve dissolution. To this, a liquid in which 44.0 g (435 mmol) of triethylamine was dissolved in 120 mL of methylene chloride was added dropwise in a temperature range from 5 degrees C to 15 degrees C. Next, stirring was performed for 30 minutes, and methylene chloride was then distilled off until the concentration thereof reached a predetermined value. To the residual liquid, 210 mL of pure water, 1.2 g of concentrated hydrochloric acid, and 450 mg of hydrosulfite were added, and washing was performed. Subsequently, washing was repeated with 210 mL of pure water five times to obtain a methylene chloride solution of a 2,2-bis(3'-cyclohexyl-4'-hydroxyphenyl)-propane oligomer having chloroformate groups at molecular terminals. The obtained solution had a chloroformate concentration of 0.75 mol/L, a solid concentration of 0.221 kg/L, and an average number of repeating units of 1.07. Hereinafter, this resulting raw material is referred to as CHZ-CF.

Synthesis Example 1

Production of PC Polymer

CHA-CF (233 mL) of Production Example 1 and methylene chloride (265 mL) were poured into a reactor equipped with a mechanical stirrer, a stirring blade, and a baffle plate. To this, p-tert-butylphenol (hereinafter denoted by PTBP) (0.192 g) was added as a terminal capping agent and stirred to be sufficiently mixed. After cooling was performed until the temperature inside the reactor was 10 degrees C, the entire amount of a prepared solution of 1,1-bis-(4-hydroxy-3-methylphenyl)cyclododecane (hereinafter denoted by OCCDE) (solution preparation method: A 1.5 N aqueous potassium hydroxide solution (148 mL) (potassium hydroxide: 14.2 g) was prepared, 0.20 g of hydrosulfite serving as an antioxidant and 22.9 g of OCCDE were then added thereto and completely dissolved by heating to 70 degrees C, and after that air-cooled to room temperature) was added to the above solution, 1.5 mL of an aqueous triethylamine solution (7 vol%) was added thereto while stirring, and stirring was continued for 90 minutes.

The resulting reaction mixture was diluted with 0.83 L of methylene chloride and 0.08 L of water, and washing was performed. The lower layer was separated and further washed with 0.23 L of water once, with 0.23 L of 0.03 N hydrochloric

acid once, and with 0.23 L of water three times in this order. The resulting methylene chloride solution was added dropwise to methanol under stirring, and the resulting reprecipitated substance was filtered and dried to obtain a PC polymer (PC-1) having a structure below.

Identification of PC Polymer

The PC polymer (PC-1) thus obtained was dissolved in methylene chloride to prepare a solution with a concentration of 0.5 g/dL, and a reduced viscosity [ηsp/C] at 20 degrees C was measured. The reduced viscosity was 0.61 dL/g. The structure and the composition of the obtained PC-1 were analyzed by $^{1}$H-NMR spectroscopy. The results confirmed that PC-1 was a PC polymer having the following repeating units and composition ratio.

[Formula 22]

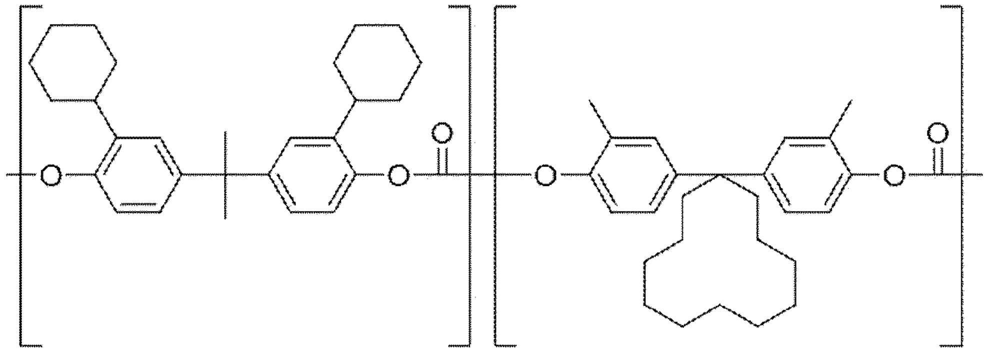

(PC-1)

The composition ratio (mol%) is CHA:OCCDE = 6:4.

Synthesis Example 2

Production of PC Polymer

CHA-CF (233 mL) of Production Example 1 and methylene chloride (265 mL) were poured into a reactor equipped with a mechanical stirrer, a stirring blade, and a baffle plate. To this, PTBP (0.207 g) was added as a terminal capping agent and stirred to be sufficiently mixed. After cooling was performed until the temperature inside the reactor was 10 degrees C, the entire amount of a prepared solution of 1,1-bis(4-hydroxy-3-methylphenyl)-3,3,5-trimethylcyclohexane (hereinafter denoted by OCTMC) (solution preparation method: A 1.5 N aqueous potassium hydroxide solution (148 mL) (potassium hydroxide: 14.2 g) was prepared and cooled to room temperature or lower, 0.18 g of hydrosulfite serving as an antioxidant and 20.4 g of OCTMC were then added thereto and completely dissolved to prepare the solution) was added to the above solution, 1.5 mL of an aqueous triethylamine solution (7 vol%) was added thereto while stirring, and stirring was continued for 90 minutes.

The resulting reaction mixture was diluted with 0.83 L of methylene chloride and 0.08 L of water, and washing was performed. The lower layer was separated and further washed with 0.23 L of water once, with 0.23 L of 0.03 N hydrochloric acid once, and with 0.23 L of water three times in this order. The resulting methylene chloride solution was added dropwise to methanol under stirring, and the resulting reprecipitated substance was filtered and dried to obtain a PC polymer (PC-2) having a structure below.

Identification of PC Polymer

The PC polymer (PC-2) thus obtained was dissolved in methylene chloride to prepare a solution with a concentration of 0.5 g/dL, and a reduced viscosity [ηsp/C] at 20 degrees C was measured. The reduced viscosity was 0.47 dL/g. The structure and the composition of the obtained PC-2 were analyzed by $^{1}$H-NMR spectroscopy. The results confirmed that PC-2 was a PC polymer having the following repeating units and composition ratio.

[Formula 23]

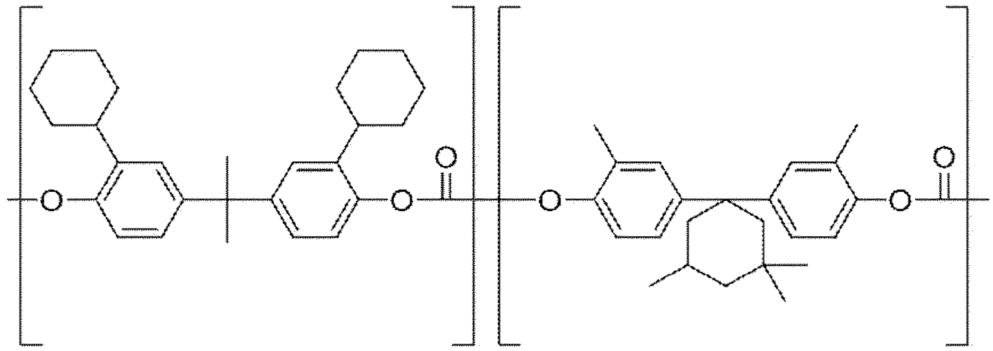

(PC-2)

The composition ratio (mol%) is CHA:OCTMC = 6:4.

Synthesis Example 3

Production of PC Polymer

CHZ-CF (235 mL) of Production Example 2 and methylene chloride (263 mL) were poured into a reactor equipped with a mechanical stirrer, a stirring blade, and a baffle plate. To this, PTBP (0.210 g) was added as a terminal capping agent and stirred to be sufficiently mixed. After cooling was performed until the temperature inside the reactor was 10 degrees C, the entire amount of a prepared OCCDE solution (solution preparation method: A 1.3 N aqueous potassium hydroxide solution (148 mL) (potassium hydroxide: 12.8 g) was prepared, 0.18 g of hydrosulfite serving as an antioxidant and 20.7 g of OCCDE were then added thereto and completely dissolved by heating to 70 degrees C, and after that air-cooled to room temperature) was added to the above solution, 1.4 mL of an aqueous triethylamine solution (7 vol%) was added thereto while stirring, and stirring was continued for 90 minutes.

The resulting reaction mixture was diluted with 0.83 L of methylene chloride and 0.08 L of water, and washing was performed. The lower layer was separated and further washed with 0.23 L of water once, with 0.23 L of 0.03 N hydrochloric acid once, and with 0.23 L of water three times in this order. The resulting methylene chloride solution was added dropwise to methanol under stirring, and the resulting reprecipitated substance was filtered and dried to obtain a PC polymer (PC-3) having a structure below.

Identification of PC Polymer

The PC polymer (PC-3) thus obtained was dissolved in methylene chloride to prepare a solution with a concentration of 0.5 g/dL, and a reduced viscosity [ηsp/C] at 20 degrees C was measured. The reduced viscosity was 0.61 dL/g. The structure and the composition of the obtained PC-3 were analyzed by $^1$H-NMR spectroscopy. The results confirmed that PC-3 was a PC polymer having the following repeating units and composition ratio.

[Formula 24]

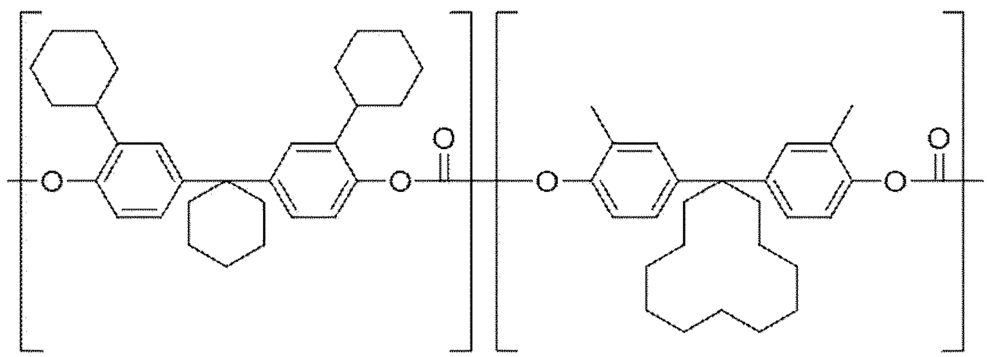

(PC-3)

The composition ratio (mol%) is CHZ:OCCDE = 6:4.

Synthesis Example 4

Production of PC Polymer

CHZ-CF (235 mL) of Production Example 2 and methylene chloride (263 mL) were poured into a reactor equipped with a mechanical stirrer, a stirring blade, and a baffle plate. To this, PTBP (0.201 g) was added as a terminal capping agent and stirred to be sufficiently mixed. After cooling was performed until the temperature inside the reactor was 10 degrees C, the entire amount of a prepared OCCDE solution (solution preparation method: A 1.3 N aqueous potassium hydroxide solution (148 mL) (potassium hydroxide: 12.8 g) was prepared and cooled to room temperature or lower, 0.18 g of hydrosulfite serving as an antioxidant and 18.4 g of OCTMC were then added thereto and completely dissolved to prepare the solution) was added to the above solution, 1.4 mL of an aqueous triethylamine solution (7 vol%) was added thereto while stirring, and stirring was continued for 90 minutes.

The resulting reaction mixture was diluted with 0.83 L of methylene chloride and 0.08 L of water, and washing was performed. The lower layer was separated and further washed with 0.23 L of water once, with 0.23 L of 0.03 N hydrochloric acid once, and with 0.23 L of water three times in this order. The resulting methylene chloride solution was added dropwise to methanol under stirring, and the resulting reprecipitated substance was filtered and dried to obtain a PC polymer (PC-4) having a structure below.

Identification of PC Polymer

The PC polymer (PC-4) thus obtained was dissolved in methylene chloride to prepare a solution with a concentration of 0.5 g/dL, and a reduced viscosity [ηsp/C] at 20 degrees C was measured. The reduced viscosity was 0.49 dL/g. The structure and the composition of the obtained PC-4 were analyzed by $^1$H-NMR spectroscopy. The results confirmed that PC-4 was a PC polymer having the following repeating units and composition ratio.

[Formula 25]

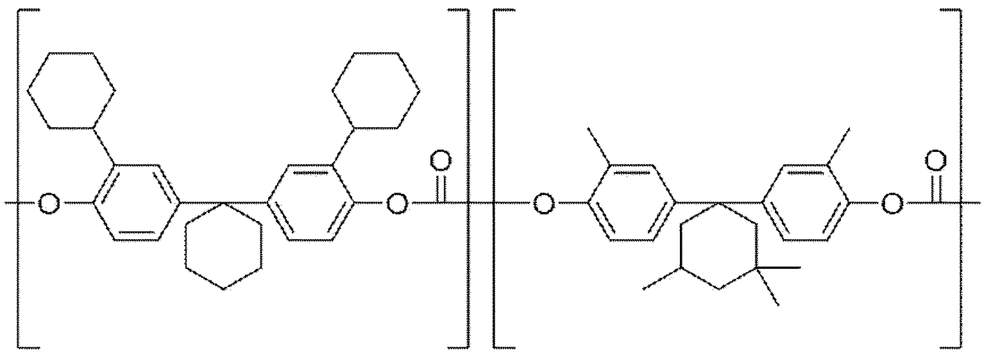

(PC-4)

The composition ratio (mol%) is CHZ:OCTMC = 6:4.

Synthesis Example 5

Production of PC Polymer

CHA-CF (233 mL) of Production Example 1 and methylene chloride (265 mL) were poured into a reactor equipped with a mechanical stirrer, a stirring blade, and a baffle plate. To this, PTBP (0.418 g) was added as a terminal capping agent and stirred to be sufficiently mixed. After cooling was performed until the temperature inside the reactor was 10 degrees C, the entire amount of a prepared solution of OCTMC and 9-(4-hydroxybenzyl)-10-(4-hydroxyphenyl) anthracene (hereinafter denoted by BIPANT) (solution preparation method: A 1.5 N aqueous potassium hydroxide solution (148 mL) (potassium hydroxide: 14.2 g) was prepared and cooled to room temperature or lower, 0.18 g of hydrosulfite serving as an antioxidant, 15.3 g of OCTMC, and 5.7 g of BIPANT were then added thereto and completely dissolved to prepare the solution) was added to the above solution, 1.5 mL of an aqueous triethylamine solution (7 vol%) was added thereto while stirring, and stirring was continued for 90 minutes.

The resulting reaction mixture was diluted with 0.83 L of methylene chloride and 0.08 L of water, and washing was performed. The lower layer was separated and further washed with 0.23 L of water once, with 0.23 L of 0.03 N hydrochloric acid once, and with 0.23 L of water three times in this order. The resulting methylene chloride solution was added dropwise to methanol under stirring, and the resulting reprecipitated substance was filtered and dried to obtain a PC polymer (PC-5)

having a structure below.

Identification of PC Polymer

The PC polymer (PC-5) thus obtained was dissolved in methylene chloride to prepare a solution with a concentration of 0.5 g/dL, and a reduced viscosity [ηsp/C] at 20 degrees C was measured. The reduced viscosity was 0.52 dL/g. The structure and the composition of the obtained PC-5 were analyzed by $^1$H-NMR spectroscopy. The results confirmed that PC-5 was a PC polymer having the following repeating units and composition ratio.

[Formula 26]

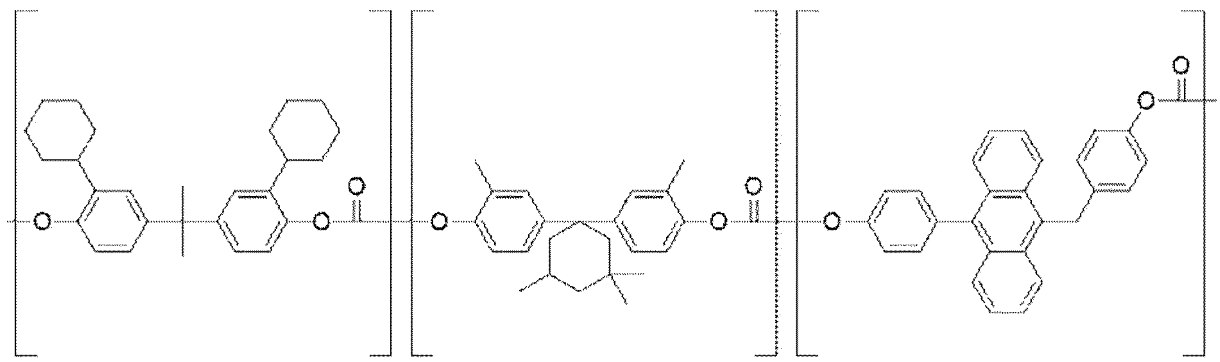

(PC-5)

The composition ratio (mol%) is CHA:OCTMC:BIPANT = 6:3:1.

Preparation of Coating Liquid Composition Formed from Polycarbonate and Preparation of Resin Film

Example 1

In a sample tube with a screw cap, 1.1 g of PC-1 was weighed and dissolved in 6 mL of tetrahydrofuran to obtain a coating liquid composition. The resulting coating liquid composition was applied to a glass plate by casting using an applicator with a gap of 500 μm to form a film. The film was air-dried for one hour and dried under reduced pressure in a vacuum dryer at a temperature of 50 degrees C for 8 hours and then at a temperature of 100 degrees C for 8 hours to remove the solvent, thereby obtaining a resin film having a thickness of 50 to 100 μm.

Example 2

A resin film was obtained as in Example 1 except that PC-2 was used in place of PC-1.

Example 3

A resin film was obtained as in Example 1 except that PC-3 was used in place of PC-1.

Example 4

A resin film was obtained as in Example 1 except that PC-4 was used in place of PC-1.

Example 5

A resin film was obtained as in Example 1 except that PC-5 was used in place of PC-1.

Example 6

In a sample tube with a screw cap, 1.5 g (15 mass%) of PC-2 and 3 g (30 mass%) of spherical silica (ADMAFINE SC2500-SQ produced by Admatechs.) were weighed and dissolved in 6.3 mL (55 mass%) of toluene to obtain a coating

liquid composition. The resulting coating liquid composition was applied to a glass plate by casting using an applicator with a gap of 600 μm to form a film. The film was air-dried for one hour and dried under reduced pressure in a vacuum dryer at a temperature of 50 degrees C for 8 hours and then at a temperature of 130 degrees C for 8 hours to remove the solvent, thereby obtaining a resin film.

Example 7

The same operations as in Synthesis Example 1 and Example 1 were performed except that CHA and CHA chloroformate were used instead of OCCDE and CHA chloroformate, to obtain a polycarbonate resin having a structure below and a resin film.

[Formula 27]

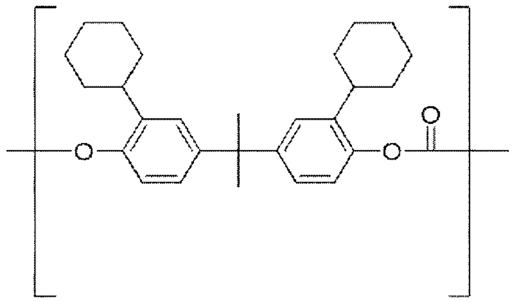

Example 8

The same operations as in Synthesis Example 1 and Example 1 were performed except that CHZ and CHZ chloroformate were used instead of OCCDE and CHA chloroformate, to obtain a polycarbonate resin having a structure below and a resin film.

[Formula 28]

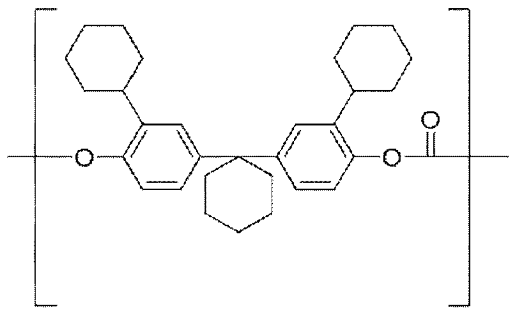

Example 10

A polycarbonate resin having a structure below and having a viscosity-average molecular weight (Mv) of 1,800 was obtained by changing only the amount of the terminal capping agent PTBP to 3.02 g in the same polymerization method as in Synthesis Example 4. However, the polycarbonate resin of Example 10 was difficult to mold into a film shape, and it was not possible to measure the dielectric properties.

[Formula 29]

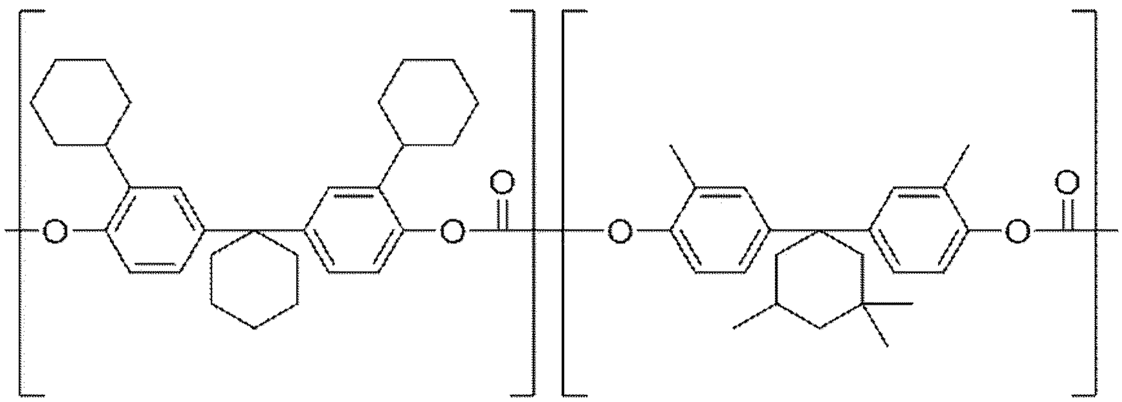

Example 11

The same operations as in Synthesis Example 1 and Example 1 were performed except that CHA and 1,1-bis-(4-hydroxy-3-methylphenyl)cyclohexane chloroformate were used instead of OCCDE and CHA chloroformate and that the bisphenol/chloroformate ratio was changed to 0.74, to obtain a polycarbonate resin having a structure below and a resin film.

[Formula 30]

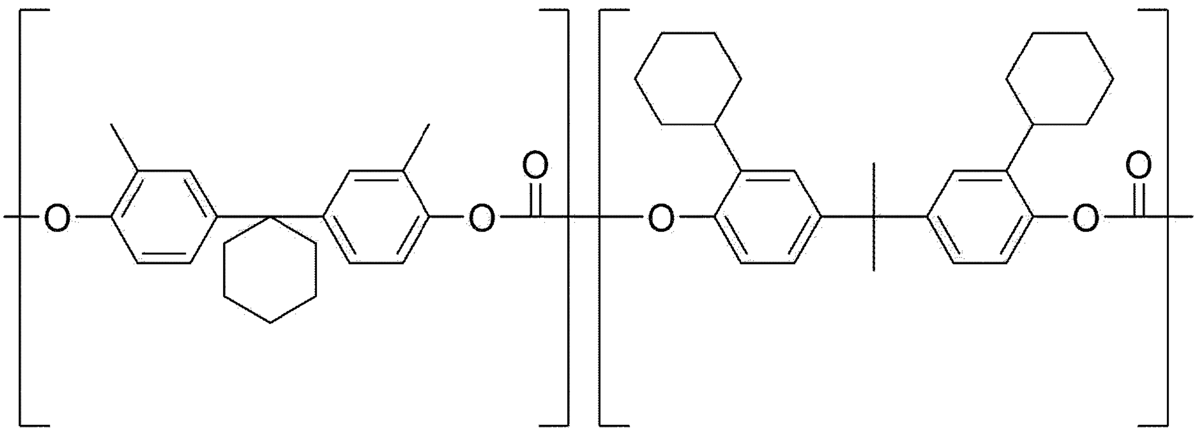

Example 12

The same operations as in Synthesis Example 1 and Example 1 were performed except that CHA and 1,1-bis-(4-hydroxy-3-methylphenyl)cyclohexane chloroformate were used instead of OCCDE and CHA chloroformate and that the bisphenol/chloroformate ratio was changed to 0.86, to obtain a polycarbonate resin having a structure below and a resin film.

[Formula 31]

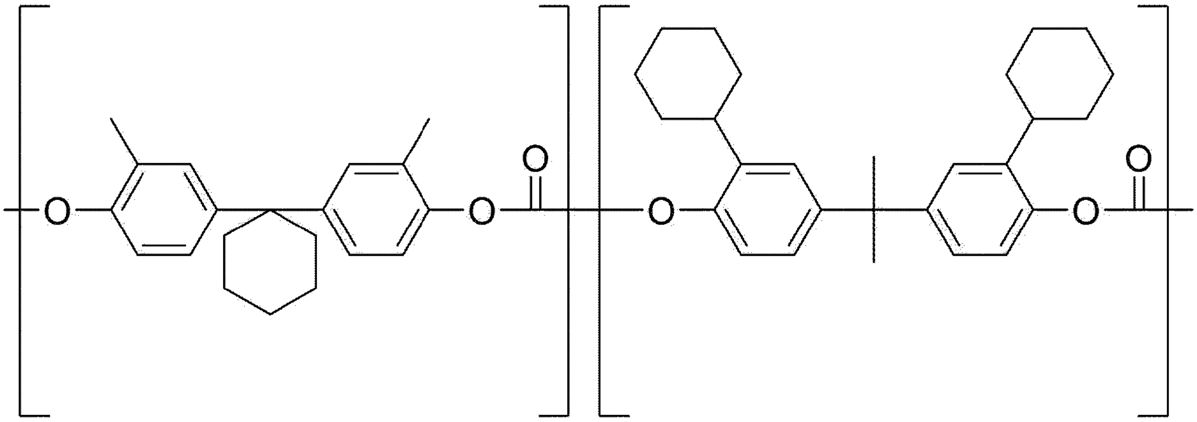

Comparative 1

The same operations as in Synthesis Example 1 and Example 1 were performed except that 1,1-bis-(4-hydroxyphenyl)propane and 1,1-bis-(4-hydroxyphenyl)propane chloroformate were used instead of OCCDE and CHA chloroformate, to obtain a polycarbonate resin having a structure below and a resin film.

[Formula 32]

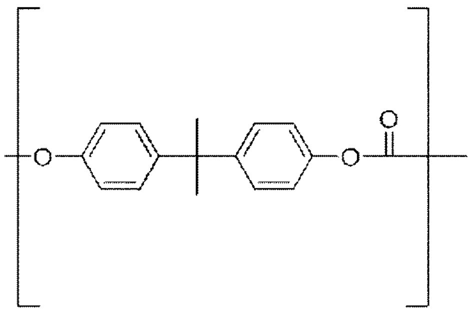

Comparative 2

The same operations as in Synthesis Example 1 and Example 1 were performed except that 1,1-bis-(4-hydroxyphenyl)cyclohexane and 1,1-bis-(4-hydroxyphenyl)cyclohexane chloroformate were used instead of OCCDE and CHA chloroformate, to obtain a polycarbonate resin having a structure below and a resin film.

[Formula 33]

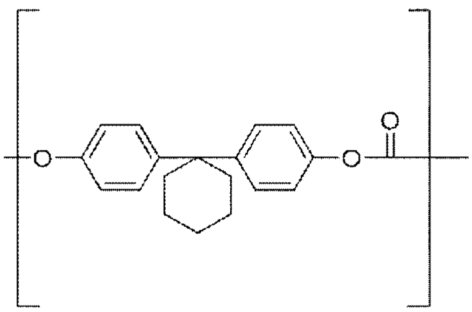

Example 9

A resin film was obtained as in Example 1 except for using a polycarbonate resin with a viscosity-average molecular weight (Mv) of 17,500 obtained by adjusting the amount of the terminal capping agent PTBP in the same polymerization method as in Synthesis Example 1.

The physical properties of the polycarbonate resin were evaluated by the following methods.

Evaluation of Viscosity-Average Molecular Weight

0.2 g of the polycarbonate resin was dissolved in 40 mL of methylene chloride, and a specific viscosity ($\eta_{sp}$) of the solution at 20 degrees C was measured. Then, Mv calculated by the following formulae was used as the viscosity-average molecular weight. The device used for the measurement was an automatic viscometer tester (VMR-052 USPC produced by RIGO), and an improved Ubbelohde type (410-UIB type) viscometer was used. The results are shown in Table 1.

$$\eta_{sp}/C = [\eta] \times (1 + 0.28 \times \eta_{sp})$$

From Schnell's equation,

$$[\eta] = 1.23 \times 10^{-5} Mv^{0.83}$$

rearranged to

$$Mv = ([\eta]/1.23 \times 10^{-5})^{1/0.83}$$

$[\eta]$: Intrinsic viscosity (limiting viscosity)
C: Sample concentration (g/L)

Evaluation of Dielectric Constant and Dissipation Factor

A square film having 60 mm in length and 60 mm in width was cut out from the resin film and conditioned for 24 hours at a room temperature of 22±1 degrees C and humidity of 33±5%. The dielectric constant (Dk) and dissipation factor (Df) were then measured at a frequency of 10 GHz using a split cylinder resonator (produced by EM labs, Inc.) and a network analyzer (Keysight Technologies). The results are shown in Table 1. The temperature dependence of dielectric properties was measured also using a small environmental test chamber (SH-662 produced by ESPEC), where the temperature was changed and the dielectric constant and dissipation factor were measured at a frequency of 10 GHz. The results are shown in Figs. 1 and 2. Further, the maximum and minimum values of Dk and Df between 30 degrees C and 150 degrees C, and the difference between these values are shown in Table 3.

Solution Viscosity Evaluation

In a sample tube, 0.27 g (5 mass%) of the resin film obtained in each of Examples 1 and 9 and 5.2 g of toluene were placed and stirred at room temperature, after which the solution viscosity was measured using a tuning fork vibro viscometer (SV-10 produced by A&D Company, Limited). The SV indication value [mPa•s x g/$cm^3$] indicates viscosity x density, serving as an index for relatively expressing a liquid viscosity. The results are shown in Table 2.

Evaluation of Glass Transition Temperature and Thermal Expansion Coefficient

A strip of film having 40 mm in length and 4 mm in width was cut out from the resin film, and measurement was performed using TMA (TMA7100 produced by Hitachi High-Tech Corporation). The results are shown in Table 1.

Measurement mode: Temperature condition for tensile test: -30 to 320 degrees C (temperature increase rate 5 degrees C/min)
Data processing method: Calculate the thermal expansion coefficient (CTE) from 40 to 100 degrees C, and use a temperature at the inflection point as the glass transition temperature (Tg)

Evaluation of Solubility in Non-Halogenated Solvent (Toluene)

In a sample tube, 0.1 g (3 mass%) of the resin film and 3.2 g of toluene were placed and stirred at room temperature. After one day, the appearance of the solution was visually confirmed. The results are shown in Table 1.

A: No insoluble matter, transparent.
B: No insoluble matter, but white turbidity was visually observed.
F: Insoluble matter observed.

Evaluation of Terminal Hydroxyl Group Content

The terminal hydroxyl group content is calculated by first calculating the molar ratio of each structure of polycarbonate using deuterated dichloromethane and 400 MHz $^1$H-NMR (produced by JEOL REASONANCE Co., Ltd.). The solution to be evaluated is prepared by adding 0.74 mL of deuterated dichloromethane to 10$\pm$0.5 mg of the resin and stirring. The weight ratio was calculated from the calculated molar ratio and the molecular weight of each structure, and the hydroxyl group content in the total weight of the polymer was calculated in ppm by mass. A case where no hydroxyl group peak was detected was recorded as "No peak detected". The results are shown in Table 1.

Evaluation of Crosslinking of Resin Film

In a sample tube with a screw cap, 1.4 g of the resin of Example 5 (functional group concentration: 0.236 mmol/g) and 94 mg of 2,2-bis[4-(4-maleimidophenoxy)phenyl]propane (hereinafter denoted by MI-BisA, functional group concentration: 3.51 mmol/g) as a curing material were weighed and dissolved in 8 mL of toluene to obtain a coating liquid composition. The resulting coating liquid composition was applied to a glass plate by casting using an applicator with a gap of 600 $\mu$m to form a film. The film was air-dried for one hour and dried under reduced pressure in a vacuum dryer at a temperature of 50 degrees C for 16 hours to remove the solvent, thereby obtaining a resin film. The resulting resin film was then heated in a reduced pressure dryer at a temperature of 160 degrees C for two hours. At the same time, the resin film of Example 2 was heated alone in a reduced pressure dryer at a temperature of 160 degrees C for two hours. After both the resin films were air-cooled to room temperature, 5 mL of methylene chloride was added to each of those, and the appearance was observed. The results are shown in Table 4.

F (Dissolved): No insoluble matter was visually observed.
A (Insoluble): No swelling, or the shape of the film was maintained with slight swelling.

Evaluation of Solution Fluidity

In a microtube having an inner diameter of 1 cm and a height of 5 cm, 20 mg of the resin obtained in each of Examples 4 and 10 and 30 mg of toluene were placed to prepare a 40 mass% toluene solution. Thereafter, the toluene solution was stirred on a shaker for 1 hour, then tilted 180 degrees and observed visually. The results are shown in Table 1.

A: It took 3 seconds or less for the solution to reach the cap of the microtube.
B: It took 3 seconds or more for the solution to reach the cap of the microtube.

Table 1

| | Viscosity-average molecular weight | Dielectric properties | | Thermal properties | | Solubility In Toluene | Terminal hydroxyl group content | Solution fluidity |
|---|---|---|---|---|---|---|---|---|
| | Mv | Dk | Df | Tg | CTE (ppm/K) | A or B or F | ppm by mass | A or B |
| Ex. 1 | 25,800 | 2.52 | 0.00165 | 158 | 88 | A | 208 | - |
| Ex. 2 | 19,000 | 2.52 | 0.00141 | 153 | 85 | A | 46 | - |
| Ex. 3 | 25,600 | 2.52 | 0.00109 | 163 | 85 | A | 48 | - |
| Ex. 4 | 20,100 | 2.56 | 0.00127 | 160 | 85 | A | 100 | B |

(continued)

| | Viscosity-average molecular weight | Dielectric properties | | Thermal properties | | Solubility In Toluene | Terminal hydroxyl group content | Solution fluidity |
|---|---|---|---|---|---|---|---|---|
| | Mv | Dk | Df | Tg | CTE (ppm/K) | A or B or F | ppm by mass | A or B |
| Ex. 5 | 21,500 | 2.56 | 0.00144 | - | - | A | No peak detected | - |
| Ex. 6 | - | 2.97 | 0.00117 | - | - | - | No peak detected | - |
| Ex. 7 | 15,400 | 2.54 | 0.00125 | 120 | 89 | A | 84 | - |
| Ex. 8 | 17,100 | 2.54 | 0.00176 | 139 | 75 | F | No peak detected | - |
| Ex. 10 | 1,800 | - | - | - | - | A | No peak detected | A |
| Ex. 11 | 18,700 | 2.58 | 0.00128 | - | - | A | No peak detected | - |
| Ex. 12 | 11,700 | 2.71 | 0.00119 | - | - | A | 936 | - |
| Comp. 1 | 50,400 | 2.76 | 0.00502 | 172 | 76 | F | No peak detected | - |
| Comp. 2 | 39,600 | 2.73 | 0.00380 | 204 | 74 | A | No peak detected | - |

Consideration

Examples 1 to 4 in which CHA or CHZ was copolymerized have lower dielectric properties compared to the homopolymer in each of Comparatives 1 and 2. In Examples 1 to 4, the solubility in toluene, which is a non-halogenated solvent, is also excellent.

Example 5 reveals that it is possible to introduce a crosslinking group into the CHA copolymer.

Example 6 reveals that it is possible to produce a film formed from spherical silica and a resin. Since silica having a high dielectric constant adversely affects Dk compared to a case using a resin alone, it is important to use a resin with lower dielectric properties.

Examples 7 and 8 using the CHA homopolymer or CHZ homopolymer have lower dielectric properties compared to the homopolymer in each of Comparatives 1 and 2.

Examples 11 and 12 reveal that the terminal hydroxyl group content can be reduced by setting the bisphenol/-chloroformate ratio at an appropriate value. It is also found out that a decrease in the terminal hydroxyl group content contributes to a decrease in Dk.

By reducing the molecular weight (Example 10) of the resin having low dielectric properties (Example 4), it was possible to impart a feature that the coating liquid had fluidity even when dissolved at a high concentration.

Table 2

| | Viscosity-average molecular weight | Dielectric properties | | Solution viscosity | |
|---|---|---|---|---|---|
| | Mv | Dk | Df | Temperature (°C) | SV indication value |
| Ex. 1 | 25,800 | 2.52 | 0.00165 | 22.4 | 3.01 |
| Ex. 9 | 17,500 | 2.55 | 0.00118 | 22.4 | 2.02 |

Consideration

Table 2 shows the effect of molecular weight differences on dielectric properties and solution viscosity for resins with the same copolymer skeleton.

From the dielectric properties of Examples 1 and 9, it is found out that even if the viscosity-average molecular weight changes, the dielectric properties do not change significantly.

From the solution viscosities of Examples 1 and 9, it is found out that Example 9 having a smaller viscosity-average molecular weight has a lower solution viscosity. This reveals that the solution viscosity varies depending on the viscosity-average molecular weight.

Table 3

| | Maximum value | | Minimum value | | Difference | |
|---|---|---|---|---|---|---|
| Ex. 1 | Dk | 2.51 | Dk | 2.48 | Dk | 0.03 |
| | Df | 0.00233 | Df | 0.00118 | Df | 0.00115 |
| Ex. 2 | Dk | 2.53 | Dk | 2.50 | Dk | 0.03 |
| | Df | 0.00202 | Df | 0.00104 | Df | 0.00098 |
| Ex. 3 | Dk | 2.52 | Dk | 2.49 | Dk | 0.03 |
| | Df | 0.00194 | Df | 0.00089 | Df | 0.00105 |
| Ex. 4 | Dk | 2.53 | Dk | 2.50 | Dk | 0.03 |
| | Df | 0.00202 | Df | 0.00101 | Df | 0.00101 |
| Ex. 7 | Dk | 2.55 | Dk | 2.53 | Dk | 0.02 |
| | Df | 0.00137 | Df | 0.00095 | Df | 0.00042 |
| Ex. 8 | Dk | 2.52 | Dk | 2.49 | Dk | 0.03 |
| | Df | 0.00157 | Df | 0.00110 | Df | 0.00047 |
| Comp. 1 | Dk | 2.78 | Dk | 2.74 | Dk | 0.04 |
| | Df | 0.01229 | Df | 0.00486 | Df | 0.00743 |
| Comp. 2 | Dk | 2.71 | Dk | 2.68 | Dk | 0.03 |
| | Df | 0.00862 | Df | 0.00339 | Df | 0.00523 |

Consideration

As shown in Fig. 1 and Table 3, it is found out that Dk has almost no temperature dependence.

As shown in Fig. 2 and Table 3, Df tends to increase as the temperature rises. This is probably because molecular motion of the resin becomes easier as the temperature rises.

Comparing polycarbonate having cyclohexyl groups at ortho positions with Comparatives 1 and 2, it is found out that the Df increase rate relative to the increase in temperature is smaller in the cases where CHA or CHZ is contained.

Table 4

| | Appearance after addition of methylene chloride |
|---|---|
| Example 2 | F |
| Resin of Example 5 + MI-BisA | A |

Consideration

It is found out that the resin film of Example 2 was completely dissolved in methylene chloride and thus no crosslinking reaction occurred even when heated. It is found out that the resin film obtained by mixing the resin of Example 5 and MI-BisA was insoluble in methylene chloride and the crosslinking reaction progressed.

## Claims

**1.** An electronic substrate material comprising a resin comprising a structure represented by Formula (UN1),

[Formula 1]

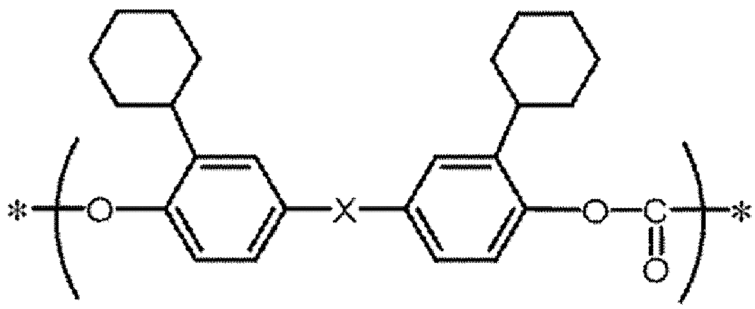

(UN1)

where: X represents a single bond, -O-, -S-, -SO-, $-SO_2-$, or an organic group having 1 to 20 carbon atoms; and * each represent a bond.

**2.** The electronic substrate material according to claim 1, wherein
the resin comprises at least one structure selected from the group consisting of a structure represented by Formula (UN1-1) and a structure represented by Formula (UN1-2),

[Formula 2]

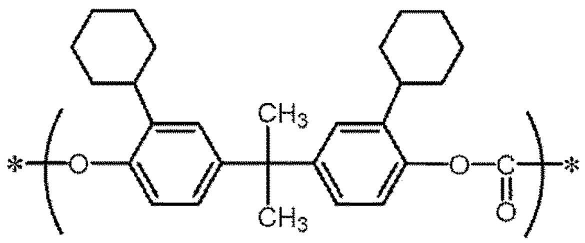

(UN1-1)

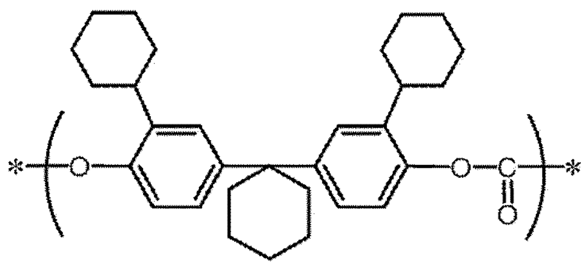

(UN1-2)

where * each represent a bond.

**3.** The electronic substrate material according to claim 1 or 2, wherein
the resin further comprises at least one structure selected from the group consisting of a structure represented by Formula (UN2), a structure represented by Formula (UN3), a structure represented by Formula (UN4), and a structure represented by Formula (UN5),

[Formula 3]

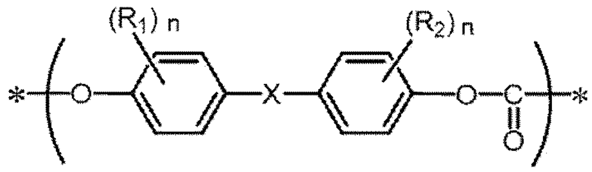

(UN2)

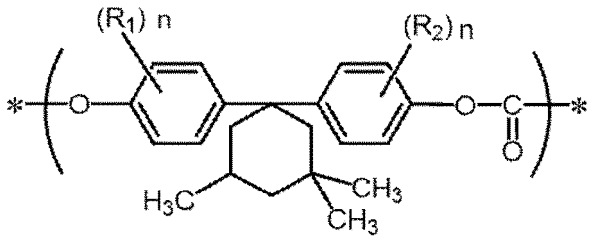

(UN3)

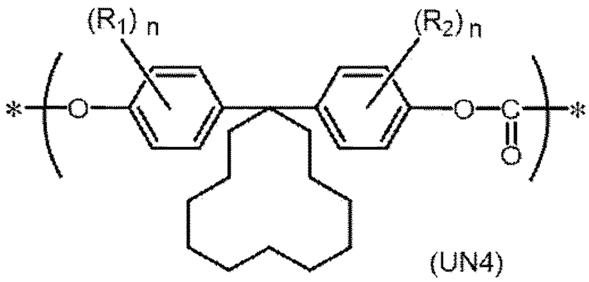

(UN4)

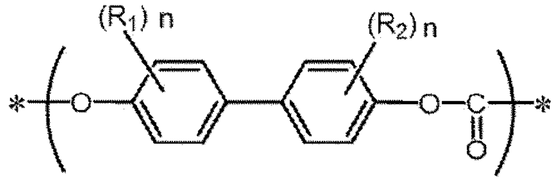

(UN5)

where: $R^1$ and $R^2$ each independently represent at least one selected from the group consisting of a halogen atom and an organic group having 1 to 12 carbon atoms, and n represents 0, 1, 2, 3, or 4; at least one $R^1$ and at least one $R^2$ present when a sum of two n is 2 or more are optionally an identical group or mutually different groups; X represents a single bond, -O-, -S-, -SO-, $-SO_2-$, or an organic group having 1 to 20 carbon atoms; and * each represent a bond.

4. The electronic substrate material according to any one of claims 1 to 3, wherein a viscosity-average molecular weight (Mv) of the resin is in a range from 1,000 to 30,000.

5. The electronic substrate material according to any one of claims 1 to 4, wherein a dielectric constant at a frequency of 10 GHz measured according to a split cylinder resonator perturbation method is 2.6 or less.

6. The electronic substrate material according to any one of claims 1 to 5, wherein a dissipation factor at a frequency of 10 GHz measured according to a split cylinder resonator perturbation method is 0.002 or less.

7. The electronic substrate material according to any one of claims 1 to 6, wherein in a case where a dielectric constant and a dissipation factor are measured in a temperature range from 30 degrees C to 150 degrees C or in a range from a temperature of 30 degrees C to a glass transition temperature of the resin according to a split cylinder resonator perturbation method, an amount of change of the dielectric constant is 0.03 or less, and an amount of change of the dissipation factor is 0.005 or less.

8. The electronic substrate material according to any one of claims 1 to 7, wherein a thermal expansion coefficient of the resin in a temperature range from 40 degrees C to 100 degrees C is 100 ppm/K or less.

9. The electronic substrate material according to any one of claims 1 to 8, wherein the resin comprises a crosslinking structure.

10. The electronic substrate material according to claim 9, wherein the resin comprises a bond between polymer chains formed by a Diels-Alder reaction.

11. The electronic substrate material according to any one of claims 1 to 10, further comprising an inorganic filler.

12. The electronic substrate material according to any one of claims 1 to 11, further comprising a non-halogenated solvent.

13. A film comprising the electronic substrate material according to any one of claims 1 to 12.

**14.** A sheet comprising the electronic substrate material according to any one of claims 1 to 12.

**15.** An electronic substrate comprising the electronic substrate material according to any one of claims 1 to 12.

**16.** A resin comprising a structure represented by Formula (UN1), a terminal hydroxyl group content of the resin being 6,000 ppm by mass or less,

[Formula 4]

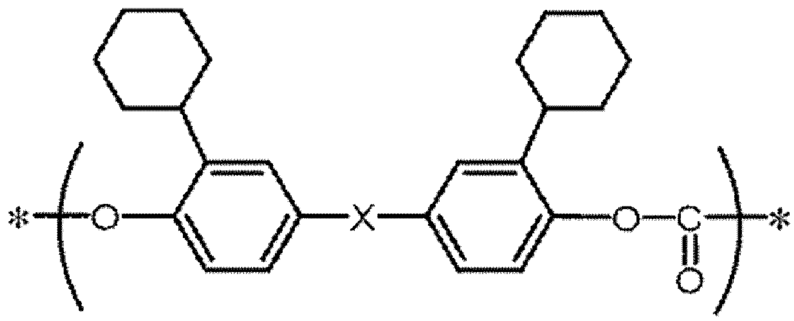

(UN1)

where: X represents a single bond, -O-, -S-, -SO-, $-SO_2-$, or an organic group having 1 to 20 carbon atoms; and * each represent a bond.

**17.** The resin according to claim 16, comprising at least one structure selected from the group consisting of a structure represented by Formula (UN1-1) and a structure represented by Formula (UN1-2),

[Formula 5]

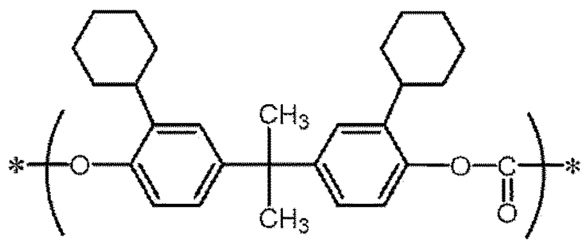

(UN1-1)

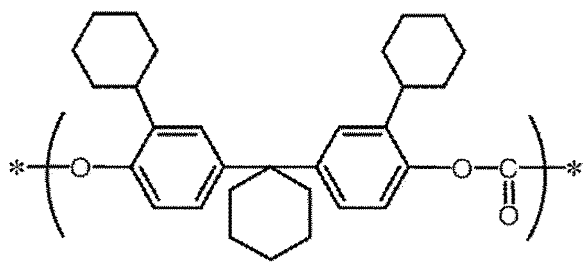

(UN1-2)

where * each represent a bond.

**18.** A method of producing a resin comprising a structure represented by Formula (UN1), the method comprising reacting a bischloroformate monomer or oligomer comprising a structure represented by Formula (UN1) with a bisphenol compound by interfacial polycondensation,

[Formula 6]

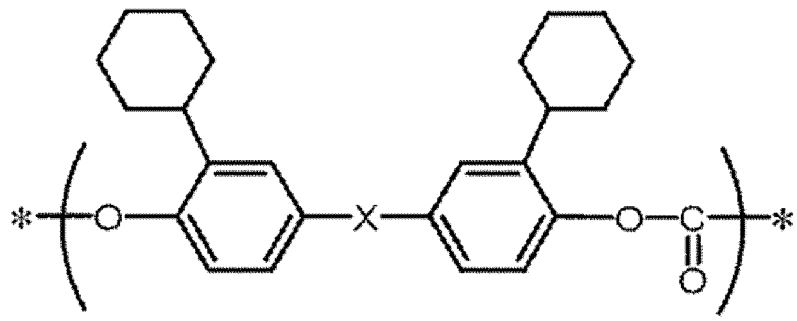

(UN1)

where: X represents a single bond, -O-, -S-, -SO-, $-SO_2-$, or an organic group having 1 to 20 carbon atoms; and * each represent a bond.

**19.** The method of producing a resin according to claim 18, wherein a terminal hydroxyl group content of the resin comprising the structure represented by Formula (UN1) is 6,000 ppm by mass or less,

[Formula 7]

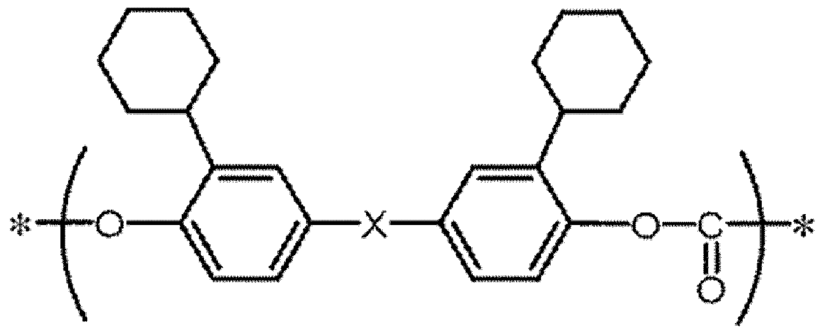

(UN1)

where: X represents a single bond, -O-, -S-, -SO-, $-SO_2-$, or an organic group having 1 to 20 carbon atoms; and * each represent a bond.

FIG.1

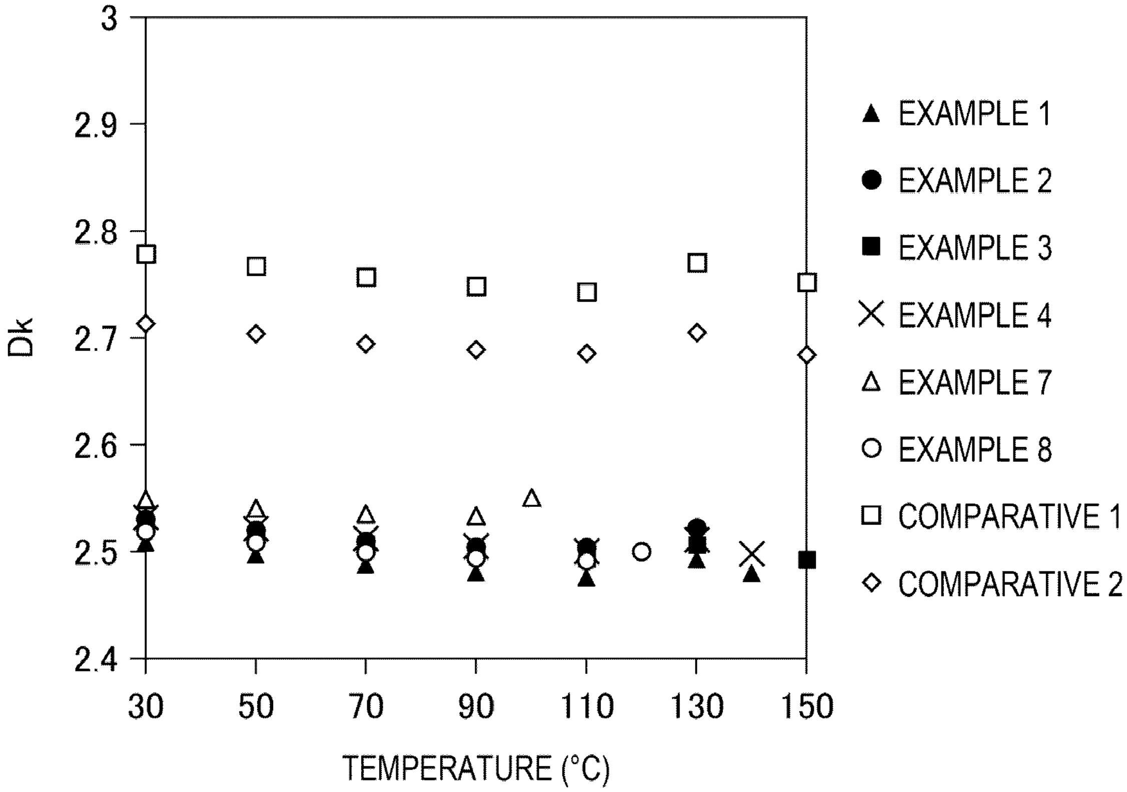
3
2.9
2.8
2.7
2.6
2.5
2.4
Dk
30
50
70
90
110
130
150
TEMPERATURE (°C)
EXAMPLE 1
EXAMPLE 2
EXAMPLE 3
EXAMPLE 4
EXAMPLE 7
EXAMPLE 8
COMPARATIVE 1
COMPARATIVE 2

FIG. 2

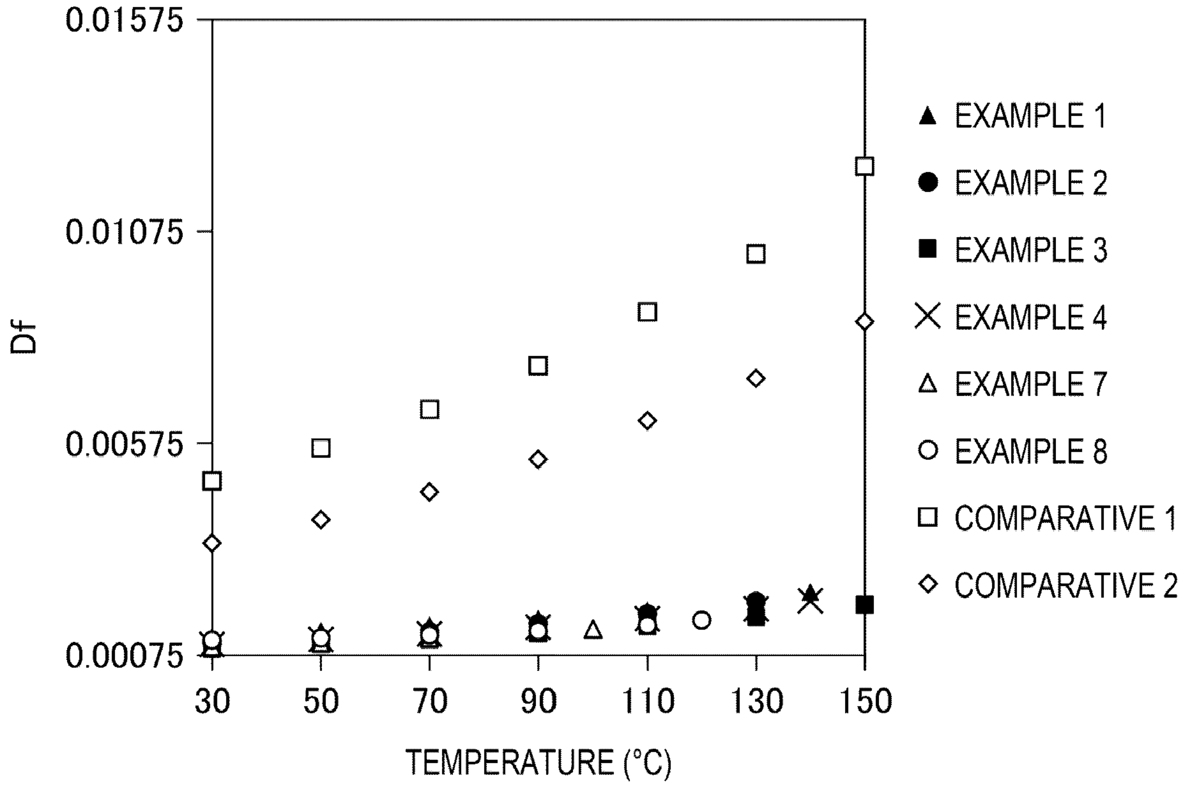
0.01575
0.01075
0.00575
0.00075
Df
30
50
70
90
110
130
150
TEMPERATURE (°C)
EXAMPLE 1
EXAMPLE 2
EXAMPLE 3
EXAMPLE 4
EXAMPLE 7
EXAMPLE 8
COMPARATIVE 1
COMPARATIVE 2

## INTERNATIONAL SEARCH REPORT

International application No.
**PCT/JP2023/045833**

**A. CLASSIFICATION OF SUBJECT MATTER**

***C08G 64/06***(2006.01)i; ***C08L 69/00***(2006.01)i; ***H05K 1/03***(2006.01)i
FI: C08G64/06; C08L69/00; H05K1/03 610H

According to International Patent Classification (IPC) or to both national classification and IPC

**B. FIELDS SEARCHED**

Minimum documentation searched (classification system followed by classification symbols)

C08G64/06; C08L69/00; H05K1/03

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| X | JP 1-156322 A (IDEMITSU KOSAN CO., LTD.) 19 June 1989 (1989-06-19) claims, p. 4, lower left column, lines 7-12, p. 8, lower left column, line 18 to lower right column, line 15, examples | 1-8, 13-17 |
| Y | claims, p. 4, lower left column, lines 7-12, p. 8, lower left column, line 18 to lower right column, line 15, examples. | 9-12 |
| A | entire text | 18-19 |
| Y | WO 2022/211025 A1 (MITSUBISHI CHEMICAL CORPORATION) 06 October 2022 (2022-10-06) claims, paragraph [0259], examples | 9-12 |
| A | entire text | 1-8, 13-19 |
| X | JP 2014-201619 A (NITTO DENKO CORPORATION) 27 October 2014 (2014-10-27) claims, examples | 16-19 |
| A | entire text | 1-15 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **31 January 2024** | **13 February 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

INTERNATIONAL SEARCH REPORT

International application No.
**PCT/JP2023/045833**

C. DOCUMENTS CONSIDERED TO BE RELEVANT

| Category* | Citation of document, with indication, where appropriate, of the relevant passages | Relevant to claim No. |
|---|---|---|
| X | JP 2006-47736 A (IDEMITSU KOSAN CO., LTD.) 16 February 2006 (2006-02-16)<br>claims, examples | 16-19 |
| A | entire text | 1-15 |
| P, X | JP 2023-20066 A (TEIJIN LIMITED) 09 February 2023 (2023-02-09)<br>claims, paragraphs [0075]-[0083], [0090], [0093]-[0097], [0127], example 6 | 1-17 |
| P, A | entire text | 18-19 |
| P, X | JP 2023-20067 A (TEIJIN LIMITED) 09 February 2023 (2023-02-09)<br>claims, paragraphs [0064]-[0072], [0079], [0082]-[0086], [0116], example 6 | 1-17 |
| P, A | entire text | 18-19 |

Form PCT/ISA/210 (second sheet) (July 2022)

**INTERNATIONAL SEARCH REPORT**

International application No.
**PCT/JP2023/045833**

**Box No. III Observations where unity of invention is lacking (Continuation of item 3 of first sheet)**

This International Searching Authority found multiple inventions in this international application, as follows:

(Invention 1) Claims 1-15

The invention in claim 1 of the present application is an "electronic substrate material" including a "resin having a structure represented by general formula (UN1)". Document 1 (see, in particular, example 4) discloses a resin corresponding to the "resin having a structure represented by general formula (UN1)", but does not disclose a specific embodiment in which the resin is used as an "electronic substrate material". Therefore, using the resin as an "electronic substrate material" is considered to be a special technical feature in claim 1 of the present application.

Accordingly, the invention in claim 1 of the present application and claims 2-15 depending therefrom are classified as invention 1.

(Invention 2) Claims 16-19

The inventions in claims 16-19 of the present application do not have the aforementioned special technical feature, and thus are classified as invention 2.

1. ☐ As all required additional search fees were timely paid by the applicant, this international search report covers all searchable claims.

2. ☑ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

**INTERNATIONAL SEARCH REPORT**
**Information on patent family members**

International application No.
**PCT/JP2023/045833**

| Patent document cited in search report | Publication date (day/month/year) | Patent family member(s) | Publication date (day/month/year) |
|---|---|---|---|
| JP 1-156322 A | 19 June 1989 | (Family: none) | |
| WO 2022/211025 A1 | 06 October 2022 | (Family: none) | |
| JP 2014-201619 A | 27 October 2014 | (Family: none) | |
| JP 2006-47736 A | 16 February 2006 | (Family: none) | |
| JP 2023-20066 A | 09 February 2023 | (Family: none) | |
| JP 2023-20067 A | 09 February 2023 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2021085051 A
- WO 2021039970 A